# EUROPÄISCHE PATENTSCHRIFT

(11) **EP 2 340 290 B1**
(45) Veröffentlichungstag und Bekanntmachung des Hinweises auf die Patenterteilung: **25.11.2015**
(21) Anmeldenummer: 09778795.6
(22) Anmeldetag: 01.10.2009
(51) Int. Cl.: C09K 11/06, H01L 51/00, H01L 51/50, H05B 33/14

(54) **NEUE MATERIALIEN FÜR ORGANISCHE ELEKTROLUMINESZENZVORRICHTUNGEN**
NOVEL MATERIALS FOR ORGANIC ELECTROLUMINESCENCE DEVICES
NOUVEAUX MATÉRIAUX POUR DISPOSITIFS ÉLECTROLUMINESCENTS ORGANIQUES

(30) Priorität: 31.10.2008 DE 102008054141
(43) Veröffentlichungstag der Anmeldung: 06.07.2011
(73) Patentinhaber: Merck Patent GmbH, 64293 Darmstadt (DE)
(72) Erfinder: PARHAM, Amir Hossain, 65929 Frankfurt (DE); PFLUMM, Christof, 60316 Frankfurt (DE); HEIL, Holger, 60389 Frankfurt (DE); BUESING, Arne, 65929 Frankfurt am Main (DE)
(86) Internationale Anmeldenummer: PCT/EP2009/007046
(87) Internationale Veröffentlichungsnummer: WO 2010/049050

(56) Entgegenhaltungen:
- WO-A1-2011/006568
- DE-A1-102006 031 990
- DE-A1-102006 035 035
- JP-A- 1 271 757
- JP-A- 2000 327 676
- MING-XIN YU: "Luminescence Properties of Aminobenzanthrones and Their Application as host Emitters in Organic Light-Emitting Devices" ADVANCED FUNCTIONAL MATERIALS, Bd. 17, 2007, Seiten 369-378, XP002555363 Weinheim
- DATABASE PUBCHEM Compound ID 21087895 5. Dezember 2007 (2007-12-05), "Compound summary" XP002555364
- GORDON RULE AND F RANDALL SMITH H: "Synthesis of mesobenzanthrones and anthanthrones by the ullmann method" JOURNAL OF THE CHEMICAL SOCIETY, CHEMICAL SOCIETY, LETCHWORTH., GB, 1. Januar 1937 (1937-01-01), Seiten 1096-1103, XP008114702 ISSN: 0368-1769

## Beschreibung

Die vorliegende Erfindung betrifft kondensierte Aromaten mit mehrfacher Ringverbrückung gemäß den allgemeinen Formeln (1), (2) und (3). Die Erfindung betrifft ferner die Verwendung der erfindungsgemäßen Verbindungen in einer organischen elektronischen Vorrichtung sowie ein Verfahren zur Herstellung der erfindungsgemäßen Verbindungen. Die Erfindung betrifft ferner eine elektronische Vorrichtung, welche die erfindungsgemäßen Verbindungen enthält.

Organische Halbleiter werden für eine Reihe verschiedenartiger Anwendungen, die im weitesten Sinne der Elektronikindustrie zugerechnet werden können, entwickelt. Der Aufbau organischer Elektrolumineszenzvorrichtungen (OLEDs), in denen diese organischen Halbleiter als funktionelle Materialien eingesetzt werden, ist beispielsweise in US 4539507, US 5151629, EP 0676461 und WO 98/27136 beschrieben. Allerdings gibt es bei diesen Vorrichtungen noch Verbesserungsbedarf:
1. In Systemen gemäß dem Stand der Technik werden in der emittierenden Schicht üblicherweise ein oder mehrere Dotanden in einem Hostmaterial verwendet. Es wäre sinnvoll, Verbindungen zu haben, die als Reinsubstanz in der emittierenden Schicht zu verwenden sind, da dies eine technische Vereinfachung bei der Device-Herstellung darstellt.
2. Bei der Lebensdauer der organischen Elektrolumineszenzvorrichtung besteht noch Verbesserungsbedarf, um diese für langlebige hochwertige Anwendungen einzusetzen.
3. Die thermische Stabilität vieler organischer Verbindungen, die derzeit in organischen Elektrolumineszenzvorrichtungen verwendet werden, ist nicht zufriedenstellend, so dass sich erhebliche Probleme sowohl bei der Reinigung des Materials durch Massensublimation wie auch beim Aufbringen des Materials durch thermische Verdampfung ergeben. Dies gilt insbesondere für Verbindungen, welche Styrylaminogruppen enthalten, wie sie häufig als blau emittierende Verbindungen verwendet werden.
4. Auch bei der Effizienz und der Betriebsspannung besteht noch Verbesserungsbedarf.

Für fluoreszierende OLEDs werden gemäß dem Stand der Technik vor allem kondensierte Aromaten, insbesondere Anthracen- oder Pyren-derivate, als Host-Materialien vor allem für blau emittierende Elektrolumineszenzvorrichtungen verwendet, z. B. 9,10-Bis(2-naphthyl)anthracen (US 5935721). Weitere Anthracenderivate sind in WO 01/076323, in WO 01/021729, in WO 04/013073, in WO 04/018588, in WO 03/087023 oder in WO 04/018587 offenbart. Host-Materialien, basierend auf Arylsubstituierten Pyrenen und Chrysenen, werden in WO 04/016575 offenbart. Es ist für hochwertige Anwendungen wünschenswert, verbesserte Host-Materialien zur Verfügung zu haben.

Als Stand der Technik bei blau emittierenden Verbindungen kann die Verwendung von Arylvinylaminen genannt werden (z. B. WO 04/013073, WO 04/016575, WO 04/018587). Diese Verbindungen sind allerdings thermisch instabil und lassen sich nicht unzersetzt verdampfen, was einen hohen technischen Aufwand für die Synthese und die OLED-Herstellung erfordert und somit einen technischen Nachteil darstellt. Einen weiteren Nachteil stellt die Emissionsfarbe dieser Verbindungen dar: Während im Stand der Technik mit diesen Verbindungen tiefblaue Emission (CIE-y-Koordinaten im Bereich von 0.15-0.18) beschrieben wird, konnten diese Farbkoordinaten nicht in einfachen Vorrichtungen gemäß dem Stand der Technik reproduziert werden. Im Gegenteil erhält man hier grünblaue Emission. Es ist daher für hochwertige Anwendungen notwendig, verbesserte Emitter besonders im Bezug auf Device- und Sublimationsstabilität sowie Emissionsfarbe zur Verfügung zu haben. Als Elektronentransportverbindung in organischen Elektrolumineszenzvorrichtungen wird meist AlQ₃ (Aluminium-tris-hydroxychinolinat) verwendet (US 4539507). Dieses hat mehrere Nachteile: Es lässt sich nicht rückstandsfrei aufdampfen, da es sich bei der Sublimationstemperatur teilweise zersetzt, was insbesondere für Produktionsanlagen ein großes Problem darstellt. Ein weiterer Nachteil ist die starke Hygroskopie von AlQ₃, ebenso wie die niedrige Elektronenbeweglichkeit, was zu höheren Spannungen und damit zu einer niedrigeren Leistungseffizienz führt. Um Kurzschlüsse im Display zu vermeiden, würde man gern die Schichtdicke erhöhen; dies ist mit AlQ₃ wegen der geringen Ladungsträgerbeweglichkeit und der daraus resultierenden Spannungserhöhung nicht möglich. Als sehr ungünstig erweist sich weiterhin die Eigenfarbe von AlQ₃ (im Feststoff gelb), die gerade bei blauen OLEDs durch Reabsorption und schwache Reemission zu Farbverschiebungen führen kann. Hier sind blaue OLEDs nur mit starken Effizienz- bzw. Farborteinbußen darstellbar. Trotz der genannten Nachteile stellt AlQ₃ bislang immer noch den besten Kompromiss für die verschiedenartigen Anforderungen an ein Elektronentransportmaterial in OLEDs dar.

Es besteht also weiterhin Bedarf an verbesserten Materialien, insbesondere Host-Materialien für fluoreszierende Emitter und Triplett-Emitter, aber auch emittierende Verbindungen, insbesondere blau emittierende Verbindungen, Lochtransportmaterialien und Elektronentransportmaterialien, die thermisch stabil sind, die in organischen elektronischen Vorrichtungen zu guten Effizienzen und gleichzeitig zu hohen Lebensdauern führen, die bei der Herstellung und beim Betrieb der Vorrichtung zu reproduzierbaren Ergebnissen führen, die synthetisch einfach und in hohen Ausbeuten zugänglich sind und die hohe thermische Stabilität aufweisen.

Die Aufgabe der vorliegenden Erfindung besteht somit in der Bereitstellung solcher Verbindungen.

Überraschend wurde gefunden, dass doppeltverbrückte aromatische Systeme gemäß unten stehender Formeln (1) bis (3) sich aufgrund hervorragender Eigenschaften als funktionelle Materialen sehr gut für die Verwendung in organischen Elektrolumineszenzvorrichtungen eignen, da sie nur einen geringen Unterschied zwischen der Anregungs- und der Emissionswellenlänge (Stokes-Shift) zeigen. Im Stand der Technik bekannte, funktionelle Materialen tragen häufig flexible Einheiten, wie olefinische Doppelbindungen, die die Anzahl der Rotationsfreiheitsgrade erhöhen und damit den Stokes-Shift vergrößern. Zusätzlich sorgen die starren Bausteine in den erfindungsgemäßen Verbindungen für eine hohe thermische Stabilität und eine hohe Glasübergangstemperatur und lassen sich dadurch unzersetzt sublimieren. Insbesondere für Anwendung bei erhöhter Temperatur ist eine hohe Glasübergangstemperatur für die Erreichung hoher Lebensdauern essentiell.

M.-X. Yu et al., Advanced Functional Materials, 2007, S. 369-378, offenbaren Verbindungen mit Benzanthron-Grundgerüst, d.h. Verbindungen mit einer einzigen Brücke zwischen Naphthyl-Gruppe und Phenyl-Gruppe in einer Phenyl-Naphthalin-Einheit, zur Verwendung in OLEDs. JP2000-327676 offenbart Verbindungen mit verbrückter Benzofluoren-Struktur als photochrome Verbindungen. H. G. Rule et al., Journal of the Chemical Society 1937, S. 1096-1103, offenbaren Verfahren zur Herstellung bestimmter Benzanthron- und Anthanthron-Verbindungen. DE102006031990 offenbart Benzindenofluoren-Verbindungen zur Verwendung in OLEDs. JP01-271757 offenbart verbrückte Benzanthron-Verbindungen mit Diazo-Gruppen als photosensitive Verbindungen. DE102006035035 offenbart peri-Xanthenoxanthen-Verbindungen zur Verwendung in OLEDs.

Die Erfindung stellt dazu Verbindungen der allgemeinen Formeln (1), (2) und (3) bereit, 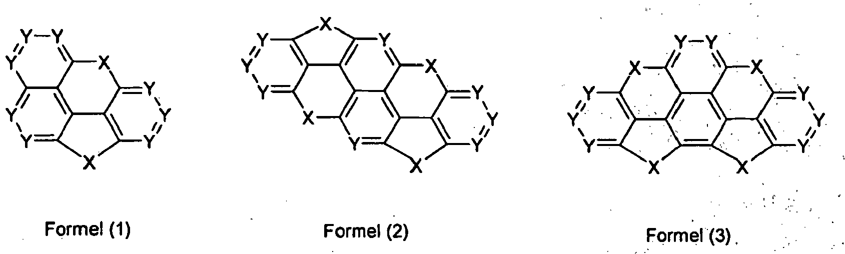 wobei gilt:
- X: ist jeweils unabhängig voneinander eine bivalente Brücke, ausgewählt aus B(R¹), C(R¹)₂, Si(R¹)₂, C=NR¹, C=C(R')₂, O, S, C=O, S=O, SO₂, N(R¹), P(R¹) und P(=O)R¹;
- Y: ist jeweils unabhängig voneinander CR oder N;
- R: ist jeweils unabhängig voneinander H, D, F, Cl, Br, I, N(R²)₂, N(Ar)₂, C(=O)Ar, P(=O)Ar₂, S(=O)Ar, S(=O)₂A CR²=CR²Ar, CN, NO₂, Si(R²)₃, B(OR²)₂, OSO₂R², eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 40 aromatischen Ringatomen, das jeweils durch einen oder mehrere nicht-aromatische Reste R substituiert sein kann, oder eine Aryloxy- oder Heteroaryloxygruppe mit 5 bis 40 aromatischen Ringatomen, die durch einen oder mehrere nicht-aromatische Reste R substituiert sein kann, oder eine Kombination dieser Systeme;
- R¹: ist jeweils unabhängig voneinander H, D, F, Cl, Br, I, CN, NO₂, B(OR²)₂, Si(R²)₃, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch -R²C=CR²-, -C≡C-, Si(R²)₂, Ge(R²)₂, Sn(R²)₂, C=O, C=S, C=Se, C=NR², -O-, -S-, -COO- oder -CONR²- ersetzt sein können und wobei ein oder mehrere H-Atome durch D, F, Cl, Br, I, CN oder NO₂ ersetzt sein können, oder ein Arylamin oder ein substituiertes Carbazol, das jeweils mit einem oder mehreren Resten R² substituiert sein kann, oder ein aromatisches oder heteroaromatisches Ringsystem mit 5 bis 40 aromatischen Ringatomen, das durch einen oder mehrere nicht-aromatische Reste R¹ substituiert sein kann, oder eine Aryloxy- oder Heteroaryloxygruppe mit 5 bis 40 aromatischen Ringatomen, die durch einen oder mehrere nicht-aromatische Reste R¹ substituiert sein kann, oder eine Kombination dieser Systeme; wobei zwei oder mehrere Substituenten R¹ auch miteinander ein mono- oder poly-cyclisches, aliphatisches oder aromatisches Ringsystem bilden können;
- R²: ist jeweils unabhängig voneinander H, D oder ein aliphatischer oder aromatischer Kohlenwasserstoffrest mit 1 bis 20 C-Atomen;
- Ar: ist jeweils unabhängig voneinander ein aromatisches oder heteroaromatisches Ringsystem mit 5 bis 40 aromatischen Ringatomen, das mit einem oder mehreren nicht-aromatischen Resten R¹ substituiert sein kann; dabei können zwei Gruppen Ar, welche an dasselbe Atom binden, auch durch eine Einfachbindung oder eine divalente Gruppe C(R¹)₂ miteinander verbunden sein.

Folgende Verbindungen sind im Stand der Technik bekannt (Journal öf the Chemical Society (1937), 1096-1103):

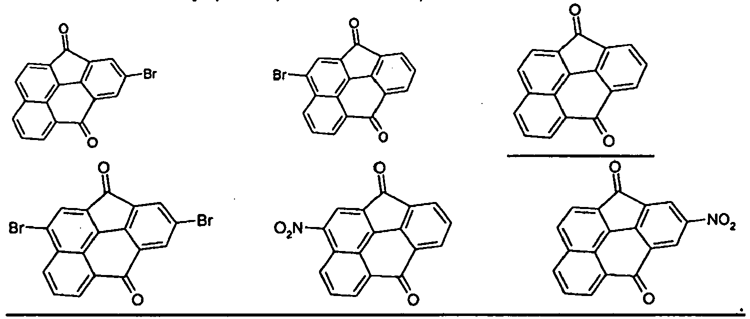

Diese Verbindungen können auch im Sinne der Erfindung verwendet werden, sind jedoch vom Stoffschutz im Rahmen dieser Erfindung ausgenommen.

Falls die oben definierten Reste innerhalb einer Verbindung mehrmals auftreten, können die Reste unabhängig voneinander bei jedem Auftreten gleich oder verschieden, entsprechend der jeweiligen Definition, sein.

Folgende allgemeine Definitionen finden ferner innerhalb dieser Erfindung Anwendung:
Eine Arylgruppe im Sinne dieser Erfindung enthält 5 bis 60 C-Atome; eine Heteroarylgruppe im Sinne dieser Erfindung enthält 2 bis 60 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, Benzothiophen, Benzofuran und Indol etc., verstanden. Besonders bevorzugt sind hierunter Naphthalin und Chinolin.

Besonders bevorzugt im Sinne dieser Erfindung ist der Rest Ar in den allgemeinen Formeln (1) bis (3) Benzol, Biphenyl, Naphthalin, Pyridin, Pyrimidin, Pyrazin, Pyridazin, Triazin, Chinolin, Isochinolin, Furan, Thiophen, Pyrrol, Benzofuran, Benzothiophen und Indol, wobei am meisten bevorzugt Benzol, Naphthalin, Pyridin, Chinolin und Isochinolin sind.

Ein aromatisches Ringsystem im Sinne dieser Erfindung enthält 5 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, N-oder O-Atom, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methyl-butyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden bevorzugt Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrirnidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diaza-anthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

In einer bevorzugten Ausführungsform der Erfindung ist die Gruppe X gleich oder verschieden bei jedem Auftreten ausgewählt aus C(R¹)₂, NR¹, O, S oder C=O. Besonders bevorzugt ist die Gruppe X gleich oder verschieden bei jedem Auftreten C(R¹)₂.

In einer weiteren bevorzugten Ausführungsform der Erfindung stehen 0, 1 oder 2 Symbole Y in den Formeln (1) bis (3) für N und die anderen Symbole Y stehen gleich oder verschieden bei jedem Auftreten für CR. Besonders bevorzugt stehen alle Symbole Y gleich oder verschieden bei jedem Auftreten für CR.

In einer weiteren bevorzugten Ausführungsform der Erfindung steht das Symbol R gleich oder verschieden bei jedem Auftreten für H, D, F, N(Ar)₂, CN, eine geradkettige Alkyl- oder Alkoxygruppe mit 1 bis 20 C-Atomen oder eine verzweigte oder cyclische Alkyl- oder Alkoxygruppe mit 3 bis 40 C-Atomen, die jeweils mit einem oder mehreren Resten R² substituiert sein kann, wobei ein oder mehrere H-Atome durch F ersetzt sein können, oder ein aromatisches oder heteroaromatisches Ringsystem mit 5 bis 25 aromatischen Ringatomen, das jeweils durch einen oder mehrere nicht-aromatische Reste R substituiert sein kann, oder eine Kombination dieser Systeme. Besonders bevorzugt steht das Symbol R gleich oder verschieden bei jedem Auftreten für H, N(Ar)₂, eine geradkettige Alkylgruppe mit 1 bis 10 C-Atomen oder eine verzweigte oder cyclische Alkylgruppe mit 3 bis 40 C-Atomen, insbesondere eine Methylgruppe, oder ein aromatisches oder heteroaromatisches Ringsystem mit 5 bis 25 aromatischen Ringatomen, das jeweils durch einen oder mehrere nicht-aromatische Reste R substituiert sein kann.

In nochmals einer bevorzugten Ausführungsform der Erfindung steht das Symbol R¹ gleich oder verschieden bei jedem Auftreten für H, D, eine geradkettige Alkyl- oder Alkoxygruppe mit 1 bis 20 C-Atomen oder eine verzweigte oder cyclische Alkyl- oder Alkoxygruppe mit 3 bis 20 C-Atomen, die jeweils mit einem oder mehreren Resten R² substituiert sein kann, wobei ein oder mehrere H-Atome durch F ersetzt sein können, oder ein aromatisches oder heteroaromatisches Ringsystem mit 5 bis 25 aromatischen Ringatomen, das durch einen oder mehrere nicht-aromatische Reste R¹ substituiert sein kann, oder eine Kombination dieser Systeme; wobei zwei oder mehrere Substituenten R¹ auch miteinander ein mono- oder polycyclisches, aliphatisches oder aromatisches Ringsystem bilden können. In einer besonders bevorzugten Ausführungsform steht das Symbol R¹ gleich oder verschieden bei jedem Auftreten für H, D, eine geradkettige Alkylgruppe mit 1 bis 10 C-Atomen oder eine verzweigte oder cyclische Alkylgruppe mit 3 bis 10 C-Atomen, insbesondere eine Methylgruppe, oder ein aromatisches oder heteroaromatisches Ringsystem mit 5 bis 10 aromatischen Ringatomen, das durch einen oder mehrere nicht-aromatische Reste R¹ substituiert sein kann, insbesondere eine Phenylgruppe, die mit einem oder mehreren nicht-aromatischen Resten R¹ substituiert sein kann; wobei zwei oder mehrere Substituenten R¹ auch miteinander ein mono- oder polycyclisches, aliphatisches oder aromatisches Ringsystem bilden können.

In einer bevorzugten Ausführungsform der Erfindungen gilt für die Verbindungen der allgemeinen Formeln (1), (2) und (3):
- X: ist jeweils unabhängig voneinander eine bivalente Brücke, ausgewählt aus C(R¹)₂, C=NR¹, C=C(R¹)₂, O, S, C=O und N(R¹),
- Y: ist jeweils unabhängig voneinander CR oder N;
- R: ist jeweils unabhängig voneinander H, D, F, N(Ar)₂, C(=O)Ar, CR²=CR²Ar, CN, eine geradkettige Alkyl-, Alkoxy- oder Thioalkoxygruppe mit 1 bis 10 C-Atomen oder eine verzweigte oder cyclische Alkyl-, Alkoxy- oder Thioalkoxygruppe mit 3 bis 10 C-Atomen, die jeweils mit einem oder mehreren Resten R² substituiert sein kann, wobei eine oder mehrere nicht benachbarte CH₂-Gruppen durch R²C=CR², C≡C, C=O, NR², O, S oder CONR² ersetzt sein können und wobei ein oder mehrere H-Atome durch D, F oder CN ersetzt sein können, oder ein aromatisches oder heteroaromatisches Ringsystem mit 5 bis 40 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Kombination dieser Systeme;
- R¹: ist jeweils unabhängig voneinander H, D, F, Cl, Br, I, CN, NO₂, B(OR²)₂, Si(R²)₃, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch -R²C=CR²-, -C≡C-, Si(R²)₂, Ge(R²)₂, Sn(R²)₂, C=O, C=S, C=Se, C=NR², -O-, -S-, -COO- oder -CONR²- ersetzt sein können und wobei ein oder mehrere H-Atome durch D, F, Cl, Br, I, CN oder NO₂ ersetzt sein können, oder Arylamine, oder substituierte Carbazole, die jeweils mit einem oder mehreren Resten R² substituiert sein können, oder ein aromatisches oder heteroaromatisches Ringsystem mit 5 bis 40 aromatischen Ringatomen, das durch einen oder mehrere nicht-aromatische Reste R¹ substituiert sein kann, oder eine Aryloxy- oder Heteroaryloxygruppe mit 5 bis 40 aromatischen Ringatomen, die durch einen oder mehrere nicht-aromatische Reste R¹ substituiert sein kann, oder eine Kombination dieser Systeme ist, wobei zwei oder mehrere Substituenten R¹ auch miteinander ein mono- oder polycyclisches, aliphatisches oder aromatisches Ringsystem bilden können;
- R²: ist jeweils unabhängig voneinander H, D oder ein aliphatischer oder aromatischer Kohlenwasserstoffrest mit 1 bis 10 C-Atomen;
- Ar: jeweils unabhängig voneinander ein aromatisches oder heteroaromatisches Ringsystem mit 5 bis 20 aromatischen Ringatomen ist, das mit einem oder mehreren nicht-aromatischen Resten R¹ substituiert sein kann; dabei können zwei Gruppen Ar, welche an dasselbe Atom binden, auch durch eine Einfachbindung miteinander verbunden sein.

In einer besonders bevorzugten Ausführungsform der Verbindungen gemäß den Formeln (1) bis (3) gilt:
- X: ist gleich oder verschieden bei jedem Auftreten ausgewählt aus C(R¹)₂, NR¹, O, S oder C=O, insbesondere C(R¹)₂;
- Y: ist gleich oder verschieden bei jedem Auftreten CR¹ oder N, wobei 0, 1 oder 2 Symbole Y in den Formeln (1) bis (3) für N stehen, insbesondere gleich oder verschieden bei jedem Auftreten CR;
- R: ist bei jedem Auftreten gleich oder verschieden H, D, F, N(Ar)₂, CN, eine geradkettige Alkyl- oder Alkoxygruppe mit 1 bis 20 C-Atomen oder eine verzweigte oder cyclische Alkyl- oder Alkoxygruppe mit 3 bis 20 C-Atomen, die jeweils mit einem oder mehreren Resten R² substituiert sein kann, wobei ein oder mehrere H-Atome durch F ersetzt sein können, oder ein aromatisches oder heteroaromatisches Ringsystem mit 5 bis 25 aromatischen Ringatomen, das jeweils durch einen oder mehrere nicht-aromatische Reste R substituiert sein kann, oder eine Kombination dieser Systeme; insbesondere bevorzugt sind H, N(Ar)₂, eine geradkettige Alkylgruppe mit 1 bis 10 C-Atomen oder eine verzweigte oder cyclische Alkylgruppe mit 3 bis 10 C-Atomen, insbesondere eine Methylgruppe, oder ein aromatisches oder heteroaromatisches Ringsystem mit 5 bis 25 aromatischen Ringatomen, das jeweils durch einen oder mehrere nicht-aromatische Reste R substituiert sein kann;
- R¹: ist gleich oder verschieden bei jedem Auftreten H, D, eine geradkettige Alkyl- oder Alkoxygruppe mit 1 bis 20 C-Atomen oder eine verzweigte oder cyclische Alkyl- oder Alkoxygruppe mit 3 bis 20 C-Atomen, die jeweils mit einem oder mehreren Resten R² substituiert sein kann, wobei ein oder mehrere H-Atome durch F ersetzt sein können, oder ein aromatisches oder heteroaromatisches Ringsystem mit 5 bis 25 aromatischen Ringatomen, das durch einen oder mehrere nicht-aromatische Reste R¹ substituiert sein kann, oder eine Kombination dieser Systeme; wobei zwei oder mehrere Substituenten R¹ auch miteinander ein mono- oder polycyclisches, aliphatisches oder aromatisches Ringsystem bilden können; insbesondere bevorzugt ist H, eine geradkettige Alkylgruppe mit 1 bis 10 C-Atomen oder eine verzweigte oder cyclische Alkylgruppe mit 3 bis 10 C-Atomen, insbesondere eine Methylgruppe, oder ein aromatisches oder heteroaromatisches Ringsystem mit 5 bis 10 aromatischen Ringatomen, das durch einen oder mehrere nicht-aromatische Reste R¹ substituiert sein kann, insbesondere eine Phenylgruppe, die mit einem oder mehreren nicht-aromatischen Resten R¹ substituiert sein kann; wobei zwei oder mehrere Substituenten R¹ auch miteinander ein mono- oder polycyclisches, aliphatisches oder aromatisches Ringsystem bilden können;
die weiteren Symbole haben die oben genannte Bedeutung.

Bevorzugte Ausführungsformen der Formeln (1) bis (3) sind die im Folgenden abgebildeten Formeln (1a) bis ((3)a), 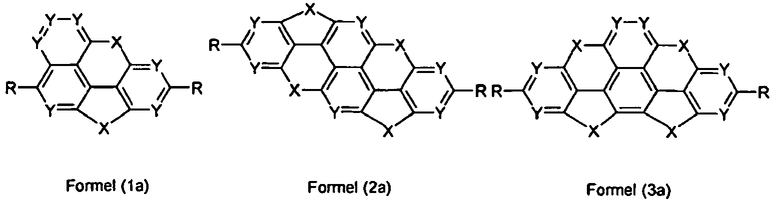 wobei die verwendeten Symbole die oben aufgeführten Bedeutungen haben und maximal 2 Symbole Y in jeder Struktur für N stehen. Insbesondere haben die verwendeten Symbole die oben aufgeführten bevorzugten Bedeutungen.

Besonders bevorzugte Ausführungsformen dieser Verbindungen sind die im Folgenden abgebildeten Verbindungen (1 b) bis (3b), 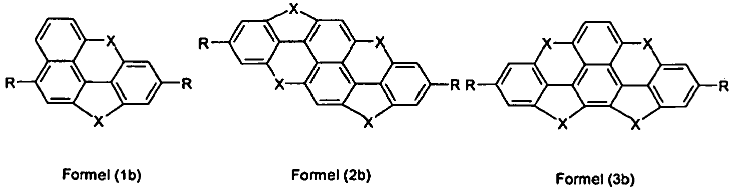 wobei R und X die oben aufgeführten Bedeutungen haben.

Ganz besonders bevorzugt sind Verbindungen der Formeln (1 b) bis (3b), in denen X gleich oder verschieden bei jedem Auftreten für C(R¹)₂, NR¹, O, S oder C=O steht, insbesondere für C(R¹)₂, wobei C(CH₃)₂ oder C(Phenyl)₂ besonders bevorzugt sind.

In besonders bevorzugten Ausführungsformen der Erfindung genügen die Verbindungen der allgemeinen Formeln (1), (2), (3), (4) oder (5) den folgenden Strukturformeln 1 bis 184. Verbindungen der allgemeinen Formeln (4) und (5) sind von den Ansprüchen nicht umfasst.

| | | |
|---|---|---|
| 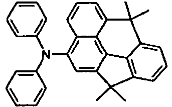 | 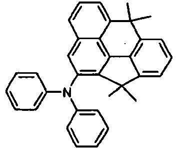 | 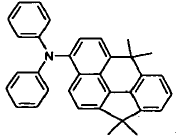 |
| 1 | 2 | 3 |
| 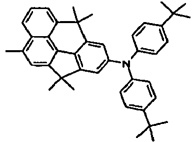 | 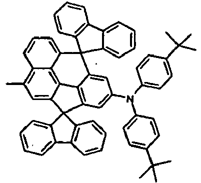 | 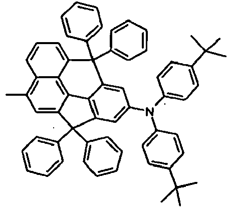 |
| 4 | 5 | 6 |
| 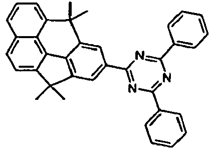 | 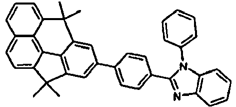 | 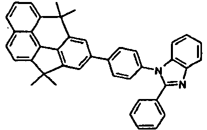 |
| 7 | 8 | 9 |
| 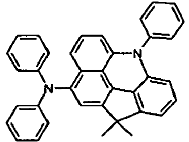 | 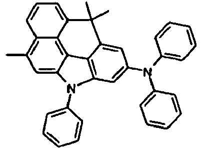 | 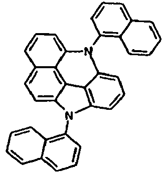 |
| 10 | 11 | 12 |
| 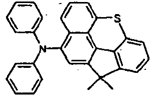 | 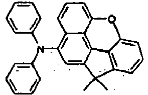 | 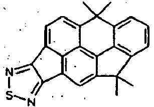 |
| 13 | 14 | 15 |
| 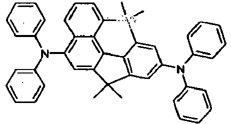 | 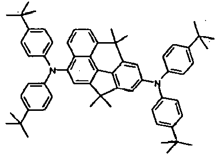 | 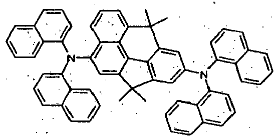 |
| 16 | 17 | 18 |
| 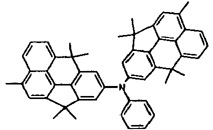 | 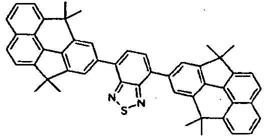 | 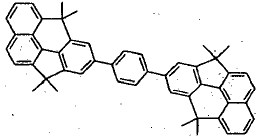 |
| 19 | 20 | 21 |
| 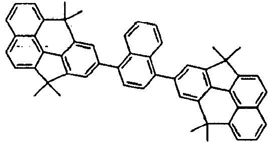 | 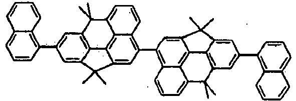 | 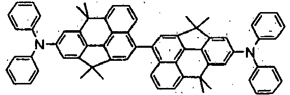 |
| 22 | 23 | 24 |
| 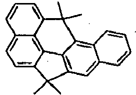 | 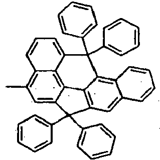 | 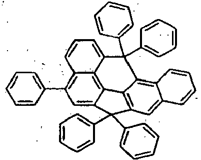 |
| 25 | 26 | 27 |
| 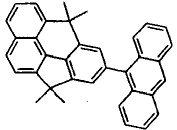 | 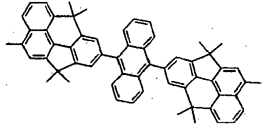 | 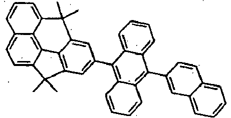 |
| 28 | 29 | 30 |
| 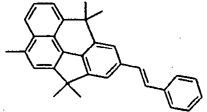 | 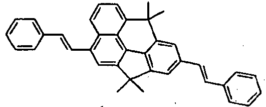 | 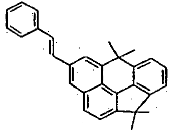 |
| 31 | 32 | 33 |
| 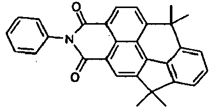 | 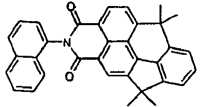 | 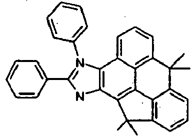 |
| 34 | 35 | 36 |
| 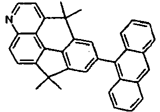 | 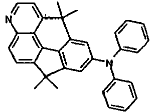 | 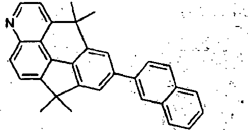 |
| 37 | 38 | 39 |
| 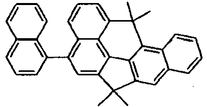 | 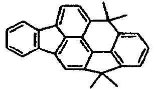 | 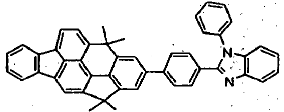 |
| 40 | 41 | 42 |
| 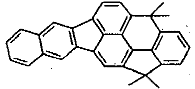 | 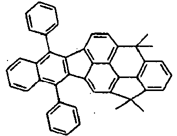 | 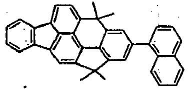 |
| 43 | 44 | 45 |
| 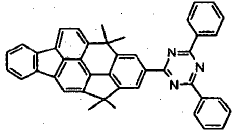 | 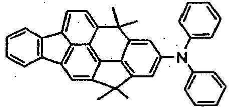 | 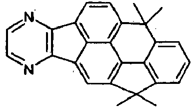 |
| 46 | 47 | 48 |
| 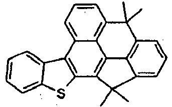 | 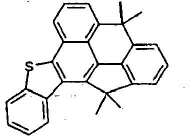 | 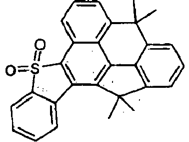 |
| 49 | 50 | 51 |
| 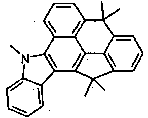 | 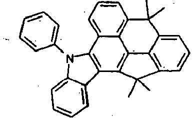 | 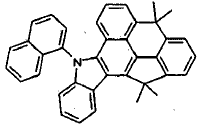 |
| 52 | 53 | 54 |
| 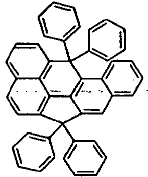 | 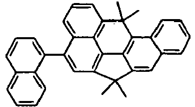 | 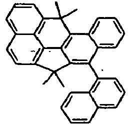 |
| 55 | 56 | 57 |
| 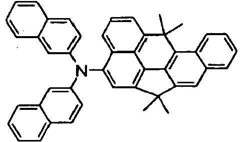 | 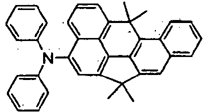 | 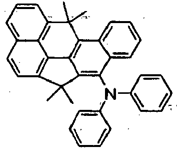 |
| 58 | 59 | 60 |
| 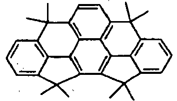 | 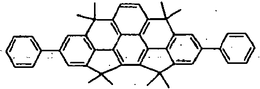 | 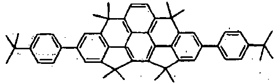 |
| 61 | 62 | 63 |
| 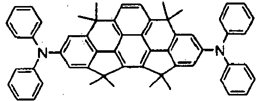 | 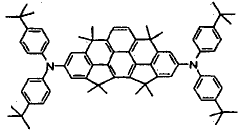 | 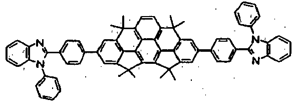 |
| 64 | 65 | 66 |
| 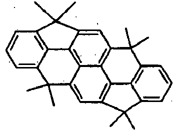 | 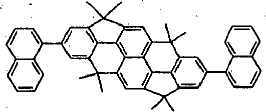 | 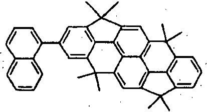 |
| 67 | 68 | 69 |
| 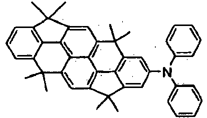 | 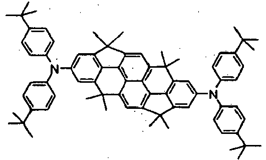 | 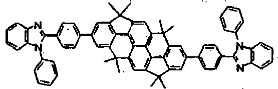 |
| 70 | 71 | 72 |
| 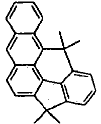 | 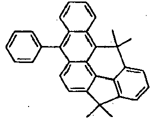 | 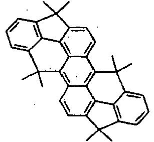 |
| 73 | 74 | 75 |
| 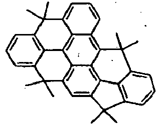 | 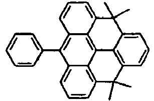 | 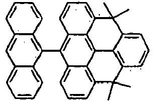 |
| 76 | 77 | 78 |
| 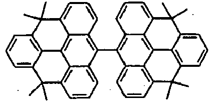 | 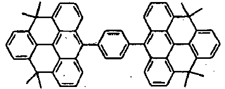 | 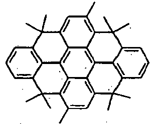 |
| 79 | 80 | 81 |
| 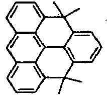 | 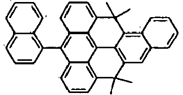 | 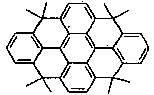 |
| 82 | 83 | 84 |
| 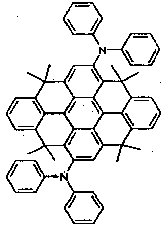 | 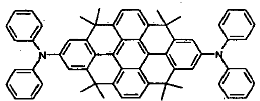 | 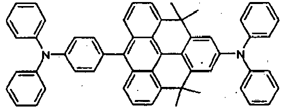 |
| 85 | 86 | 87 |
| 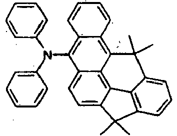 | 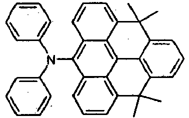 | 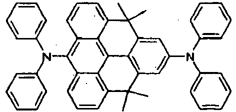 |
| 88 | 89 | 90 |
| 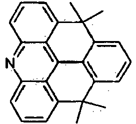 | 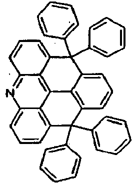 | 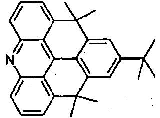 |
| 91 | 92 | 93 |
| 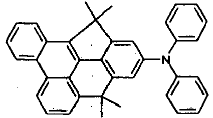 | 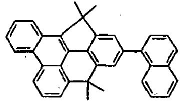 | 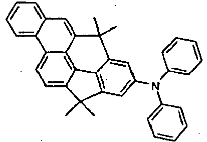 |
| 94 | 95 | 96 |
| 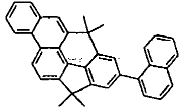 | 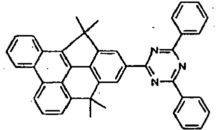 | 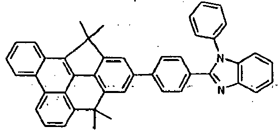 |
| 97 | 98 | 99 |
| 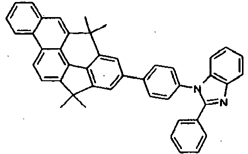 | 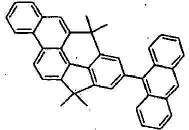 | 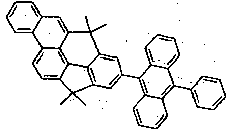 |
| 100 | 101 | 102 |
| 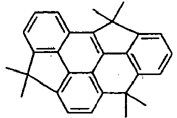 | 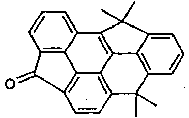 | 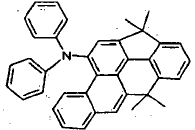 |
| 103 | 104 | 105 |
| 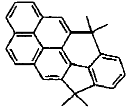 | 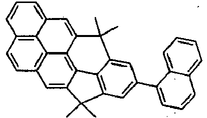 | 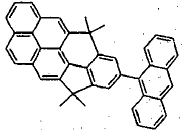 |
| 106 | 107 | 108 |
| 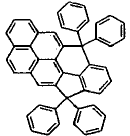 | 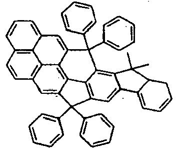 | 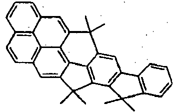 |
| 109 | 110 | 111 |
| 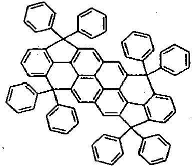 | 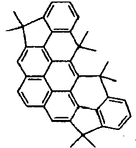 | 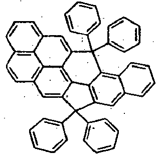 |
| 112 | 113 | 114 |
| 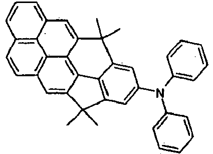 | 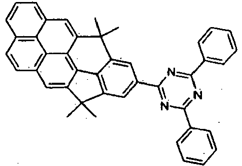 | 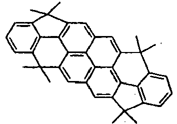 |
| 115 | 116 | 117 |
| 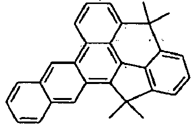 | 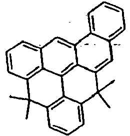 | 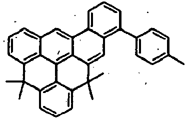 |
| 118 | 119 | 120 |
| 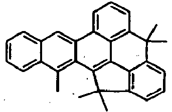 | 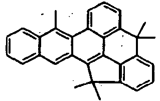 | 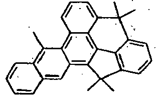 |
| 121 | 122 | 123 |
| 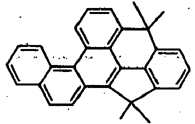 | 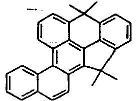 | 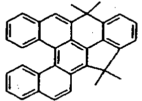 |
| 124 | 125 | 126 |
| 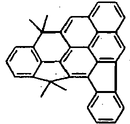 | 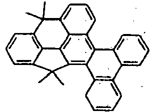 | 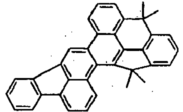 |
| 127 | 128 | 129 |
| 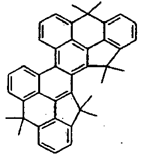 | 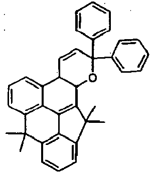 | 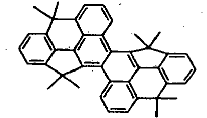 |
| 130 | 131 | 132 |
| 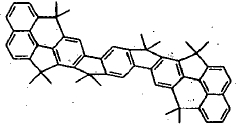 | 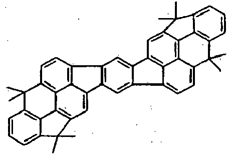 | 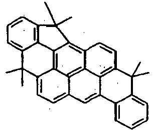 |
| 133 | 134 | 135 |
| 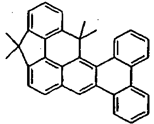 | 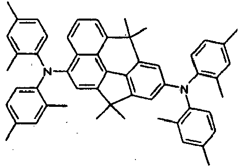 | 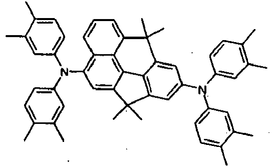 |
| 136 | 137 | 138 |
| 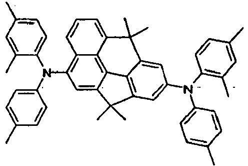 | 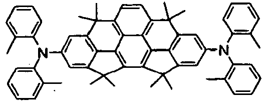 | 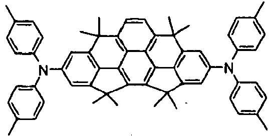 |
| 139 | 140 | 141 |
| 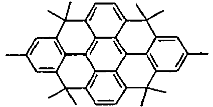 | 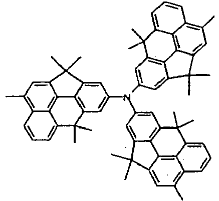 | 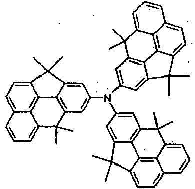 |
| 142 | 143 | 144 |
| 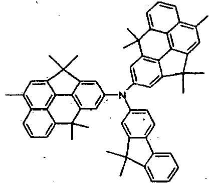 | 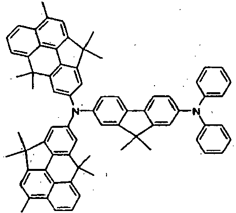 | 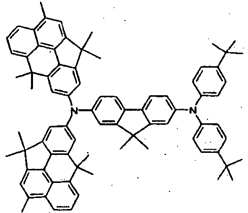 |
| 145 | 146 | 147 |
| 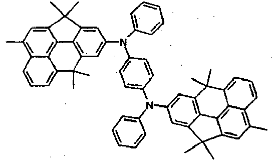 | 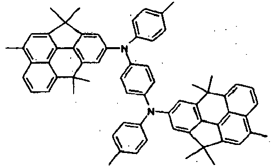 | 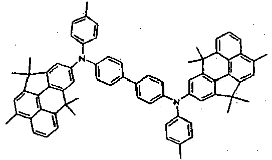 |
| 148 | 149 | 150 |
| 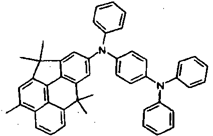 | 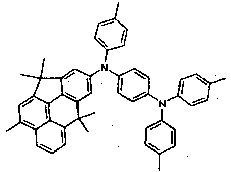 | 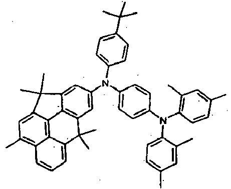 |
| 151 | 152 | 153 |
| 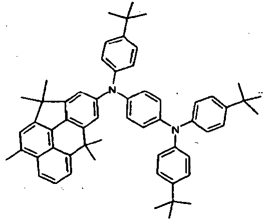 | 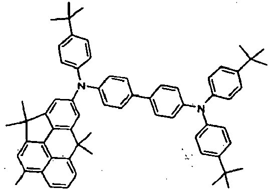 | 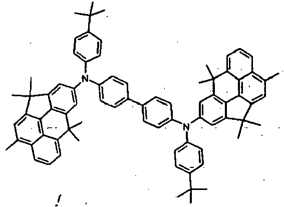 |
| 154 | 155 | 156 |
| 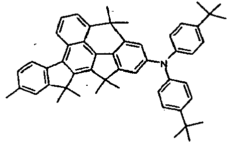 | 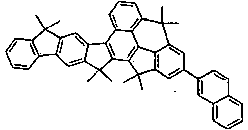 | 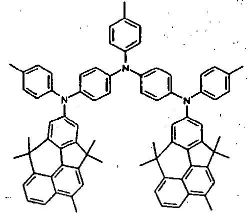 |
| 157 | 158 | 159 |
| 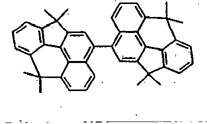 | 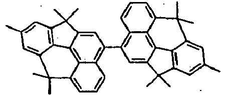 | 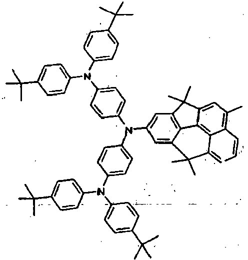 |
| 160 | 161 | 162 |
| 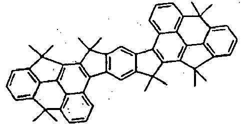 | 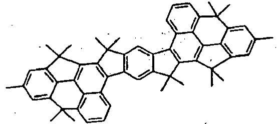 | 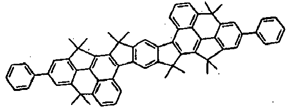 |
| 163 | 164 | 165 |
| 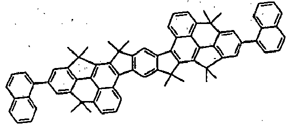 | 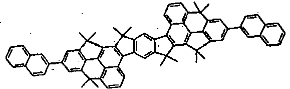 | 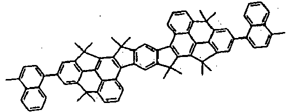 |
| 166 | 167 | 168 |
| 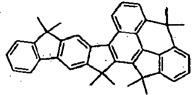 | 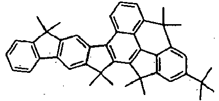 | 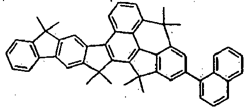 |
| 169 | 170 | 171 |
| 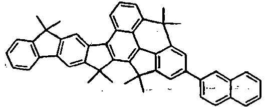 | 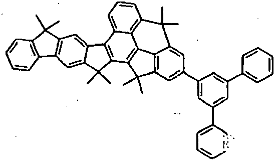 | 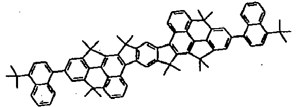 |
| 172 | 173 | 174 |
| 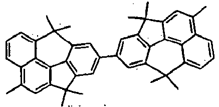 | 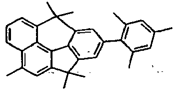 | 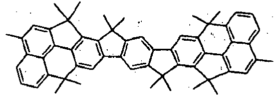 |
| 175 | 176 | 177 |
| 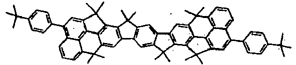 | 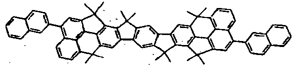 | 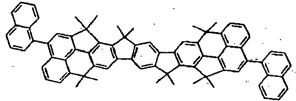 |
| 178 | 179 | 180 |
| 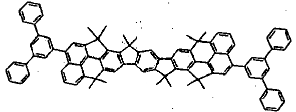 | 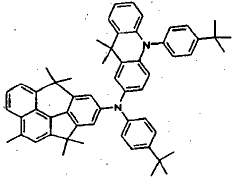 | 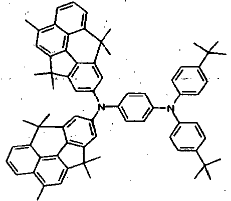 |
| 181 | 182 | 183 |
| 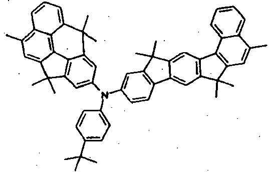 | | |
| 184 | | |

In den oben definierten Verbindungen kann es bevorzugt sein, wenn eine oder mehrere polymerisierbare funktionelle Gruppen oder eine oder mehrere elektronenziehende oder elektronenliefernde Gruppen in den Verbindungen vorhanden sind.

Falls elektronenziehende Gruppen in die Verbindungen der Formeln (1) bis (3) eingebracht sind, beispielsweise Imidazol-, Triazin- oder Pyrimidinderivate oder andere elektronenziehende Gruppen, resultieren Elektronentransportmaterialien, welche entsprechend als solche eingesetzt werden können. Eine Substitution mit elektronenlieferenden Gruppen, beispielsweise Arylaminogruppen, führt hingegen zu Lochinjektions- bzw. Lochtransportmaterialien, welche entsprechend als solche eingesetzt werden können. Je nach der genauen Struktur derartiger Materialien können diese Arylamino-substituierten Verbindungen auch als fluoreszierende Dotanden eingesetzt werden. Falls die oben genannten erfindungsgemäßen Verbindungen unsubstituiert bzw. einfach aromatisch substituiert sind, können sie als fluoreszierende Emitter oder als Hostmaterialien für fluoreszierende oder phosphoreszierende Emitter eingesetzt werden.

Falls polymerisierbare funktionelle Gruppen in den oben definierten Verbindungen vorhanden sind, können diese für eine Polymerisation der Verbindungen genutzt werden. Auf diese Weise können Dimere, Oligomere, Polymere oder Dendrimere hergestellt werden. Hierzu sind insbesondere solche Verbindungen bevorzugt, welche mit reaktiven Abgangsgruppen, wie Chlor, Brom, lod, Boronsäure oder Boronsäureester substituiert sind. Diese können auch als Comonomere zur Erzeugung entsprechender konjugierter, teilkonjugierter oder nicht-konjugierter Polymere, Oligomere oder auch als Kern von Dendrimeren Verwendung finden. Die Polymerisation erfolgt dabei bevorzugt über die Halogenfunktionalität bzw. die Boronsäurefunktionalität.

Als Oligomer wird im Sinne dieser Erfindung eine Verbindung bezeichnet, welche etwa drei bis neun Wiederholungseinheiten aufweist. Als Polymer im Sinne der Erfindung wird eine Verbindung verstanden, welche zehn oder mehr Wiederholungseinheiten aufweist.

Weiterer Gegenstand der Erfindung sind daher Dimere, Oligomere, Polymere oder Dendrimere, enthaltend eine oder mehrere Verbindungen gemäß Formel (1), (2) oder (3), wie oben definiert, wobei einer oder mehrere der Reste R Bindungen zu der nächsten Wiederholeinheit darstellen. Je nach Verknüpfung der Verbindungen bilden die Verbindungen eine Hauptkette eines Oligomers oder Polymers oder eine Seitenkette eines Oligomers oder Polymers oder ein Dendrimer. Die Oligomere, Polymere oder Dendrimere können konjugiert, teilkonjugiert oder nicht-konjugiert sein. Die Oligomere oder Polymere können linear, verzweigt oder dendritisch sein. In den linear verknüpften Strukturen können die Einheiten gemäß Formeln (1) bis (3) sowohl direkt miteinander verknüpft sein oder sie können über eine bivalente Gruppe, beispielsweise über eine substituierte oder unsubstituierte Alkylengruppe, über ein Heteroatom oder über eine bivalente aromatische oder heteroaromatische Gruppe, miteinander verknüpft sein. In verzweigten Strukturen können beispielsweise drei oder mehrere Einheiten gemäß Formel (1) bis (3) über eine trivalente oder höhervalente Gruppe, beispielsweise über eine trivalente oder höhervalente aromatische oder heteroaromatische Gruppe, zu einem verzweigten Oligomer oder Polymer verknüpft sein.

Für die Wiederholeinheiten gemäß Formel (1) bis (3) in Oligomeren und Polymeren gelten dieselben Bevorzugungen, wie oben beschrieben.

Zur Herstellung der Oligomere, Polymere oder Dendrimere werden die funktionalisierten Verbindungen der allgemeinen Formel (1), (2) oder (3) homopolymerisiert oder mit weiteren Monomeren copolymerisiert. Im Falle, dass Copolymere hergestellt werden, ist es bevorzugt, wenn die Verbindungen gemäß Formel (1), (2) oder (3) im Bereich von 0.1 bis 50 Mol-% vorhanden sind. Geeignete und bevorzugte Comonomere sind gewählt aus Fluorenen (z. B. gemäß EP 842208 oder WO 00/22026), Spirobifluorenen (z. B. gemäß EP 707020, EP 894107 oder WO 06/061181), Paraphenylenen (z. B. gemäß WO 92/18552), Carbazolen (z. B. gemäß WO 04/070772 oder WO 04/113468), Thiophenen (z. B. gemäß EP 1028136), Dihydrophenanthrenen (z. B. gemäß WO 05/014689), cis- und trans-Indenofluorenen (z. B. gemäß WO 04/041901 oder WO 04/113412), Ketonen (z. B. gemäß WO 05/040302), Phenanthrenen (z. B. gemäß WO 05/104264 oder DE 102005037734) oder auch mehreren dieser Einheiten. Diese Polymere enthalten üblicherweise noch weitere Einheiten, beispielsweise emittierende (fluoreszierende oder phosphoreszierende) Einheiten, wie z. B. Vinyltriarylamine (z. B. gemäß DE 102005060473) oder phosphoreszierende Metallkomplexe (z. B. gemäß WO 06/003000). und/oder Ladungstransporteinheiten, insbesondere solche basierend auf Triarylaminen.

Da in die erfindungsgemäßen Verbindungen selektiv entweder eine oder zwei Halogenfunktionalitäten, bevorzugt Brom, eingeführt werden können, ist es möglich, gezielt Dimere, Trimere, Tetramere, Pentamere, etc. aufzubauen. So können beispielsweise zwei monofunktionalisierte Verbindungen in einer Suzuki-Kupplung oder einer Yamamoto-Kupptung zu den entsprechenden Dimeren gekuppelt werden. Durch Halogenierung und weitere Kupplung mit monofunktionalisierten Verbindungen sind die entsprechenden Tetramere selektiv zugänglich. Weiterhin können zwei monofunktionalisierte Verbindungen mit einer difunktionalisierten Verbindung zu dem entsprechenden Trimer gekuppelt werden. Die Kupplungsreaktion ist hier bevorzugt eine Suzuki-Kupplung. Durch Halogenierung, bevorzugt Bromierung, und weitere Kupplung mit monofunktionalisierten Verbindungen sind die entsprechenden Pentamere selektiv zugänglich. Ebenso ist es möglich, die Dimere, Trimere, Tetramere, Pentamere, etc. weiter zu funktionalisieren, indem diese beispielsweise halogeniert und in einer Hartwig-Buchwald-Kupplung mit einem Arylamin zu den entsprechenden aromatischen Aminen umgesetzt werden.

Die erfindungsgemäßen Verbindungen gemäß Formel (1) bis (3) können nach dem Fachmann bekannten Syntheseschritten dargestellt werden. So lassen sich die verschiedenen Grundgerüste beispielsweise durch säurekatalysierte Cyclisierung der entsprechenden tertiären Alkohole darstellen, wie allgemein in Schema 1 für Verbindungen gemäß Formel (1) bis (3) gezeigt. Dieses Grundgerüst lässt sich nach Standardmethoden funktionalisieren, beispielsweise durch Friedel-Crafts-Alkylierung oder -Acylierung. Weiterhin lässt sich das Grundgerüst nach Standardmethoden der organischen Chemie bromieren. Die bromierten Verbindungen stellen die Basis für weitere Funktionalisierungen dar. So können sie durch Suzuki-Kupplung mit Arylboronsäuren oder Arylboronsäurederivaten oder mit Organozinnverbindungen gemäß Stille zu erweiterten aromatischen Verbindungen umgesetzt werden. Durch Kupplung mit aromatischen oder aliphatischen Aminen gemäß Hartwig-Buchwald erhält man die entsprechenden Amine. Weiterhin können die bromierten Derivate via Lithiierung und Reaktion mit Elektrophilen wie Benzonitril und anschließender saurer Hydrolyse zu Ketonen oder mit Chlordiphenylphosphinen und anschließender Oxidation zu Phosphinoxiden umgesetzt werden.

Als Ausgangspunkt können in der Synthese z.B. die Dimethyl-2-bromisophthalate (Organic Letters 2006, 8(25), 5841-5844) oder 4-Methylnaphthalinboronsäure (WO 99/10339) verwendet werden.

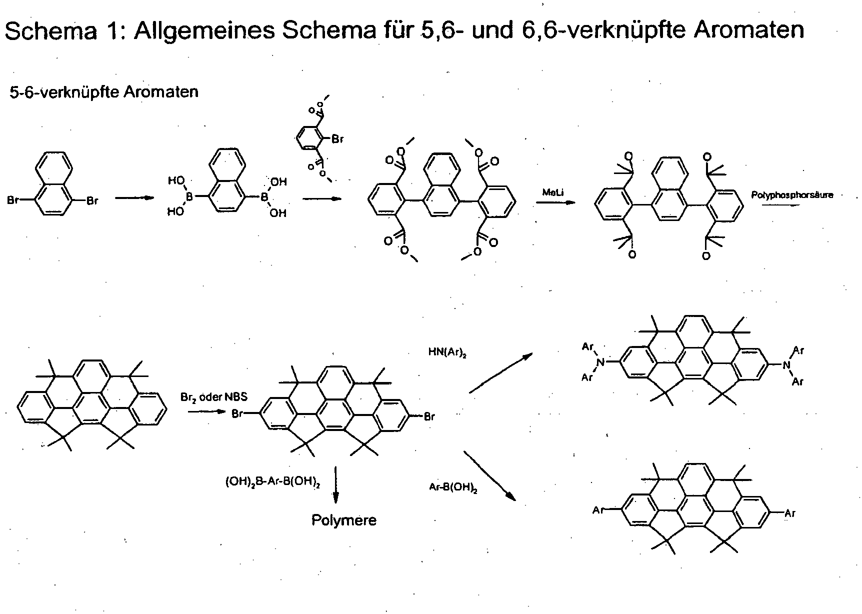

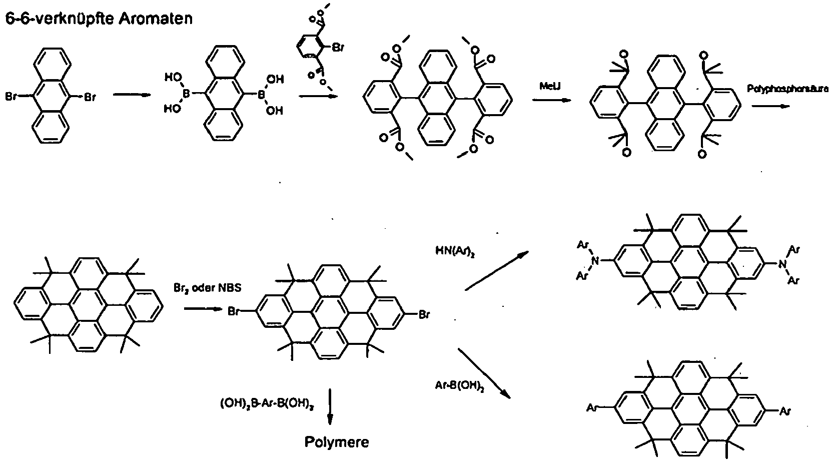

Gegenstand der Erfindung ist entsprechend auch ein Verfahren zur Herstellung der erfindungsgemäßen Verbindungen der allgemeinen Formeln (1), (2) oder (3), gekennzeichnet durch die Schritte
a) Kupplung eines funktionalisierten Naphthalins oder eines funktionalisierten Anthracens oder eines entsprechenden anderen funktionalisierten kondensierten Aromaten mit einer aromatischen und/oder heteroaromatischen Verbindung,
b) Bildung einer oder mehrerer bivalenter Brücken zwischen dem Naphthalin oder dem Anthracen und der aromatischen und/oder heteroaromatischen Verbindung über eine Ringschlussreaktion.

Als weiterer Schritt kann
c) eine Funktionalisierung des durch die Schritte a) und b) erhaltenen Grundkörpers durch Chlorierung, Bromierung oder Iodierung,
d) gefolgt von Hartwig-Buchwald-Kupplung mit einem aromatischen Amin oder Suzuki-Kupplung mit einer Arylboronsäure bzw. einem Arylboronsäurederivat oder eine Polymerisation erfolgen.

Bei dem erfindungsgemäßen Verfahren wird die bivalente Brücke vorzugsweise aus B(R¹), C(R¹)₂, Si(R¹)₂, C=NR¹, C=C(R¹)₂, O, S, C=O, S=O, SO₂, N(R¹), P(R¹) und P(=O)R¹ gebildet, wobei die verwendeten Symbole und Indizes die oben angegebene Bedeutung haben.

Die funktionelle Gruppe am Naphthalin oder Anthracen ist bevorzugt eine Boronsäuregruppe bzw. ein Boronsäurederivat. Die funktionellen Gruppen für die Kupplung am Aromaten oder Heteroaromaten sind bevorzugt Chlor, Brom oder lod, besonders bevorzugt Brom. Die weiteren funktionellen Gruppen am Aromaten oder Heteroaromaten sind bevorzugt zwei Estergruppen der Formel C(=O)-O-R, wobei R für eine Alkylgruppe mit 1 bis 20 C-Atomen steht. Die weitere Funktionalisierung zur Bildung der bivalenten Brücke kann beispielsweise durch Addition einer Organolithium-Verbindung oder einer Grignard-Verbindung erfolgen, wodurch ein tertiärer Alkohol erhalten wird.

Gegenstand der Erfindung ist auch die Verwendung der erfindungsgemäßen Verbindungen bzw. die Verwendung der Dimere, Oligomere, Polymere oder Dendrimere in einer organischen elektronischen Vorrichtung. Bei der organischen elektronischen Vorrichtung handelt es sich vorzugsweise um eine organische Leuchtdiode (OLED), eine organische integrierte Schaltung (O-IC), einen organischen Feld-Effekt-Transistor (O-FT), einen organischen Dünnfilmtransistor (O-TFT), einen organischen lichtemittierenden Transistor (O-LET), eine organische Solarzelle (O-SC), einen organischen optischen Detektor, einen organischen Photorezeptor, ein organisches Feld-Quench-Device (O-FQD), eine lichtemittierende elektrochemische Zelle (LEC) oder eine organische Laserdiode (O-Laser).

Bevorzugt werden die erfindungsgemäßen Verbindungen innerhalb der elektronischen Vorrichtung als Emitterverbindungen, als Hostmaterial, als Lochtransportverbindungen und/oder Elektronentransportverbindungen verwendet. Zur Verwendung als Lochinjektions- bzw. Lochtransportmaterial werden die erfindungsgemäßen Verbindungen bevorzugt mit elektronenlieferenden Gruppen, beispielweise Arylaminogruppen oder dergleichen, versehen. Zur Verwendung als Elektronentransportmaterialien werden die erfindungsgemäßen Verbindungen vorzugsweise mit elektronenziehenden Gruppen, beispielsweise Imidazol-, Triazin- oder Pyrimidinderivaten, versehen. Zur Verwendung als Hostmaterial eignen sich bevorzugt die erfindungsgemäßen Verbindungen in ihrer unsubstituierten Form bzw. einfach aromatisch substituierten Form. Dadurch können sie als Hostmaterialien für fluoreszierende oder phosphoreszierende Emitter eingesetzt werden. Für die Verwendung als Emitter ist es bevorzugt, wenn mindestens ein Substituent R eine Arylaminogruppe N(Ar)₂ oder eine Gruppe CR²=CR²Ar darstellt oder die Verbindung einen unsubstituierten Kohlenwasserstoff darstellt.

Durch den Einsatz von zweifach 5- bzw. 6-Ring verbrückten Aromaten in den erfindungsgemäßen Vorrichtungen ergibt sich gegenüber dem Stand der Technik der Vorteil, dass diese längere Lebensdauern bei gleichzeitig höherer Effizienz aufweisen. Außerdem lassen sich diese Verbindungen ohne merkliche Zersetzung auch in größeren Mengen sublimieren und sind daher deutlich leichter zu handhaben als viele Materialien gemäß dem Stand der Technik.

Gegenstand der Erfindung ist auch die Verwendung der erfindungsgemäßen Verbindungen, je nach genauer Struktur, als Ladungstransportmaterial und/oder Ladungsinjektionsmaterial, vorzugsweise in einer entsprechenden Schicht. Dies können sowohl Lochtransportschichten, Lochinjektionsschichten, Elektronentransportschichten oder Elektroneninjektionsschichten sein. Auch der Einsatz als Ladungsblockiermaterial, beispielsweise Lochblockiermaterial, Elektronenblockiermaterial oder Excitonenblockiermaterial, ist möglich.

Ebenfalls Gegenstand der Erfindung sind organische elektronische Vorrichtungen bzw. organische Elektrolumineszenzvorrichtungen (organische Leuchtdioden, OLEDs), organische integrierte Schaltungen (O-ICs), organische Feld-Effekt-Transistoren (O-FETs), organische Dünnfilmtransistoren (O-TFTs), organische lichtemittierende Transistoren (O-LETs), organische Solarzellen (O-SGs), organische optische Detektoren, organische Photorezeptoren, organische Feld-Quench-Devices (O-FQDs), lichtemittierende elektrochemische Zellen (LECs) oder organische Laserdioden (O-Laser), insbesondere aber organische Elektrolumineszenzvorrichtungen (= organische Leuchtdioden, OLEDs), enthaltend eine oder mehrere Verbindungen gemäß Formel (1) bis (3), wie oben definiert.

Bevorzugt liegen die Verbindungen der Formeln (1) bis (3) in der elektronischen Vorrichtung innerhalb einer Schicht vor.

Gegenstand der Erfindung ist somit auch eine Schicht, insbesondere eine organische Schicht, enthaltend eine oder mehrere Verbindungen der Formel (1) bis (3), wie oben definiert.

Für die organischen elektronischen Vorrichtungen gelten für die Verbindungen der Formeln (1) bis (3) dieselben Bevorzugungen, wie oben beim Stoffschutz ausgeführt.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Excitonenblockierschichten und/oder Ladungserzeugungsschichten (Charge-Generation Layers, IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer). Ebenso können zwischen zwei emittierende Schichten eine oder mehrere Interlayers eingebracht sein, welche beispielsweise eine Excitonenblockierende Funktion aufweisen. Es sei aber darauf hingewiesen, dass nicht notwendigerweise jede dieser Schichten vorhanden sein muss. Diese Schichten können Verbindungen der allgemeinen Formeln (1) bis (3), wie oben definiert, enthalten.

In einer bevorzugten Ausführungsform der Erfindung werden die Verbindungen gemäß Formeln (1) bis (3) als emittierende Verbindungen in einer emittierenden Schicht eingesetzt. Dabei kann die organische Elektrolumineszenzvorrichtung eine emittierende Schicht enthalten, oder sie kann mehrere emittierende Schichten enthalten, wobei mindestens eine emittierende Schicht mindestens eine Verbindung gemäß Formeln (1) bis (3), wie oben definiert, enthält. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 05/011013).

Wenn die Verbindungen gemäß Formeln (1) bis (3) als emittierende Verbindungen in einer emittierenden Schicht eingesetzt werden, ist eine bevorzugte Anwendung in Kombination mit einem oder mehreren Matrixmaterialien (= Hostmaterialien). Unter einem Hostmaterial wird in einem System aus Matrix (Host) und Dotand diejenige Komponente verstanden, die in dem System im höheren Anteil vorliegt. Bei einem System aus einem Host und mehreren Dotanden wird als Host diejenige Komponente verstanden, deren Anteil der höchste in der Mischung ist.

Die Mischung aus Verbindungen gemäß Formeln (1) bis (3) und dem Matrixmaterial enthält zwischen 1 und 50 Vol.-%, vorzugsweise zwischen 2 und 50 Vol.-%, besonders bevorzugt zwischen 3 und 40 Vol.-%, insbesondere zwischen 5 und 15 Vol.-% der Verbindungen gemäß Formeln (1) bis (3) bezogen auf die Gesamtmischung aus Emitter und Matrixmaterial. Entsprechend enthält die Mischung zwischen 99 und 50 Vol.-%, vorzugsweise zwischen 98 und 50 Vol.-%, besonders bevorzugt zwischen 97 und 60 Vol.%, insbesondere zwischen 95 und 85 Vol.-% des Matrixmaterials bezogen auf die Gesamtmischung aus Emitter und Matrixmaterial.

Als Hostmaterialien (Matrixmaterialien) kommen hierfür Materialien verschiedener Stoffklassen in Frage. Bevorzugte Hostmaterialien sind ausgewählt aus den Klassen der Oligoarylene (z. B. 2,2',7,7'-Tetraphenylspirobifluoren gemäß EP 676461 oder Dinaphthylanthracen), insbesondere der Oligoarylene enthaltend kondensierte aromatische Gruppen, der Oligoarylenvinylene (z. B. DPVBi oder Spiro-DPVBi gemäß EP 676461), der polypodalen Metallkomplexe (z. B. gemäß WO 04/081017), der lochleitenden Verbindungen (z. B. gemäß WO 04/058911), der elektronenleitenden Verbindungen, insbesondere Ketone, Phosphinoxide, Sulfoxide, etc. (z. B. gemäß WO 05/084081 und WO 05/084082), der Atropisomere (z. B. gemäß WO 06/048268), der Boronsäurederivate (z. B. gemäß WO 06/117052) oder der Benzanthracene (z. B. gemäß der nicht offen gelegten Anmeldung DE 102007024850.6). Besonders bevorzugte Hostmaterialien sind ausgewählt aus den Klassen der Oligoarylene, enthaltend Naphthalin, Anthracen, Benzanthracen und/oder Pyren oder Atropisomere dieser Verbindungen, der Ketone, der Phosphinoxide und der Sulfoxide. Ganz besonders bevorzugte Hostmaterialien sind ausgewählt aus den Klassen der Oligoarylene, enthaltend Anthracen, Benzanthracen und/oder Pyren oder Atropisomere dieser Verbindungen. Unter einem Oligoarylen im Sinne dieser Erfindung soll eine Verbindung verstanden werden, in der mindestens drei Aryl- bzw. Arylengruppen aneinander gebunden sind. Ganz besonders bevorzugt sind 9,10-Diarylanthracenderivate, wobei mindestens eine Arylgruppe eine kondensierte Arylgruppe ist, oder 2,9,10-Triarylanthracenderivate, wobei mindestens eine Arylgruppe eine kondensierte Arylgruppe ist.

Eine weitere bevorzugte Anwendung ist die Verwendung der Verbindung als Hostmaterial für fluoreszierende oder phosphoreszierende Emitter. Bevorzugt gilt für Verbindungen, welche als Matrixmaterial für phosphoreszierende Emitter verwendet werden, dass die verbrückenden Gruppen X gleich oder verschieden ausgewählt sind aus C(R¹)₂ und NR¹, wobei eine oder mehrere Gruppen X gleich NR¹ sind und wobei R¹ wie oben definiert ist und besonders bevorzugt eine elektronenarme Heteroarylgruppe darstellt, z. B. Triazin, Pyrimidin, Pyrazin, Pyridin oder Imidazol.

Der Anteil des Hostmaterials gemäß Formel (1) bis (3) in der emittierenden Schicht beträgt dann zwischen 50.0 und 99.9 Vol.-%, bevorzugt zwischen 80.0 und 99.5 Vol.-%, besonders bevorzugt zwischen 90.0 und 99.0 Vol.-%. Entsprechend beträgt der Anteil des Dotanden zwischen 0.1 und 50.0 Vol.-%, bevorzugt zwischen 0.5 und 20.0 Vol.-%, besonders bevorzugt zwischen 1.0 und 10.0 Vol.-%.

Bevorzugte Dotanden sind gewählt aus der Klasse der Monostyrylamine, der Distyrylamine, der Tristyrylamine, der Tetrastyrylamine und der Arylamine. Unter einem Monostyrylamin wird eine Verbindung verstanden, die eine Styrylgruppe und mindestens ein Amin enthält, welches bevorzugt aromatisch ist. Unter einem Distyrylamin wird eine Verbindung verstanden, die zwei Styrylgruppen und mindestens ein Amin enthält, welches bevorzugt aromatisch ist. Unter einem Tristyrylamin wird eine Verbindung verstanden, die drei Styrylgruppen und mindestens ein Amin enthält, welches bevorzugt aromatisch ist. Unter einem Tetrastyrylamin wird eine Verbindung verstanden, die vier Styrylgruppen und mindestens ein Amin enthält, welches bevorzugt aromatisch ist. Unter einem Arylamin bzw. einem aromatischen Amin im Sinne dieser Erfindung wird eine Verbindung verstanden, die drei aromatische oder heteroaromatische Ringsysteme direkt an den Stickstoff gebunden enthält, davon bevorzugt mindestens ein kondensiertes Ringsystem mit mindestens 14 aromatischen Ringatomen. Die Styrylgruppen sind besonders bevorzugt Stilbene, die auch an der Doppelbindung oder an den Aromaten weiter substituiert sein können. Beispiele für derartige Dotanden sind substituierte oder unsubstituierte Tristilbenamine oder weitere Dotanden, die beispielsweise in WO 06/000388, WO 06/058737, WO 06/000389, WO 07/065549 und WO 07/115610 beschrieben sind. Weiterhin sind Verbindungen gemäß WO 06/122630 als Dotanden bevorzugt. Bevorzugte Dotanden sind weiterhin Arylaminderivate oder Bis(diarylamin)derivate von Monobenzoindenofluoren oder Dibenzoindenofluoren, beispielsweise gemäß WO 08/006449 oder WO 07/140847. Nochmals weiterhin bevorzugte Dotanden sind die in der nicht offen gelegten Anmeldung DE 102008035413.9 offenbarten Verbindungen.

Eine mögliche weitere Verwendung von Verbindungen gemäß Formel (1) bis (3) ist die Verwendung als Lochtransport- oder Lochinjektionsmaterial in einer Lochtransport- oder einer Lochinjektionsschicht. Diese Verwendung eignet sich insbesondere dann, wenn eine oder mehrere
Brücken X für S oder NR¹ stehen und/oder wenn ein oder mehrere Reste R für N(Ar)₂ stehen. Derartige Verbindungen können weiterhin auch in einer Elektronenblockierschicht eingesetzt werden.

Eine weitere mögliche Verwendung von Verbindungen gemäß Formel (1) bis (3) ist die Verwendung als Elektronentransportmaterial in einer Elektronentransportschicht. Hierfür eignen sich insbesondere Verbindungen gemäß Formel (1) bis (3), welche mit mindestens einem elektronenarmen Heteroaromaten substituiert sind. Elektronenarme Heteroaromaten sind 6-Ring-Heteroaromaten mit mindestens einem Stickstoffatom und entsprechende kondensierte Systeme, beispielsweise Pyridin, Pyrazin, Pyrimidin, Pyridazin, Triazin, Chinolin, Chinoxalin oder Phenanthrolin, oder 5-Ring-Heteroaromaten mit mindestens einem Stickstoffatom und einem weiteren Heteroatom, ausgewählt aus N, O oder S, und entsprechende kondensierte Systeme, beispielsweise Pyrazol, Imidazol, Oxazol, Oxadiazol oder Benzimidazol. Wenn die Verbindungen gemäß Formel (1) bis (3) als Elektronentransportmaterial verwendet werden, steht die Brücke X bevorzugt für C(R¹)₂- Außerdem eignen sich die Verbindungen auch dann als Elektronentransportmaterialien, wenn mindestens eine Brücke X für C=O, P(=O)R¹, SO oder SO₂ steht. Derartige Verbindungen können weiterhin auch in einer Lochblockierschicht eingesetzt werden.

Weiterhin bevorzugt ist eine organische Elektrolumineszenzvorrichtung, wobei eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder InkJet Druck (Tintenstrahldruck), hergestellt werden. Hierfür sind lösliche Verbindungen nötig, welche gegebenenfalls durch geeignete Substitution erhalten werden. Diese Methoden eignen sich insbesondere auch für Oligomere und Polymere.

Diese Verfahren sind dem Fachmann generell bekannt und können von ihm ohne Probleme auf organische Elektrolumineszenzvorrichtungen enthaltend Verbindungen gemäß Formeln (1) bis (3), wie oben definiert, angewandt werden.

Die Erfindung wird nun anhand einiger nicht als beschränkend auf den Umfang der Erfindung zu verstehenden Beispielen näher erläutert.

### Beispiele:

Die nachfolgenden Synthesen werden, sofern nicht anders angegeben, unter einer Schutzgasatmosphäre in getrockneten Lösungsmitteln durchgeführt.

### Schema 2:

### Allgemeine Synthesevorschrift:

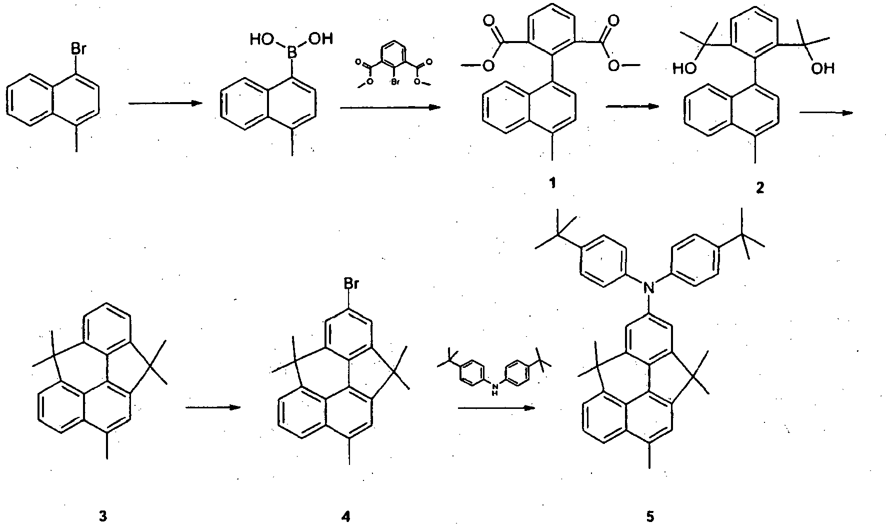

### Beispiel 1:

### Synthesevorschrift zur Herstellung von 2-(4-Methyl-naphthalin-1-yl)-isophthalsäure-dimethylester 1:

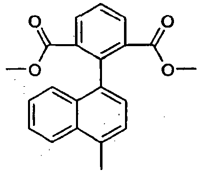

35 g (148 mmol) 4-Methylnaphthalinboronsäure, 33.8 g (124 mmol) Dimethyl-2-bromisophthalat und 220 mL 2 M Na₂CO₃ Lösung werden in 1 L Toluol und 1 L EtOH suspendiert, das Gemisch mit N₂ gesättigt, 2.9 g (3 mmol) Tetrakis(triphenylphosphin)-palladium(0) zugegeben und für 2 h zum Sieden erhitzt. Das Gemisch wird in 3 L einer Mischung aus - Wasser/MeOH/6 M HCl 1:1:1 gegossen, der beige Niederschlag abgesaugt, mit Wasser, EtOH und Toluol gewaschen und getrocknet Der Gehalt an Produkt beträgt gemäß ¹H-NMR ca. 95 % bei einer Gesamtausbeute von 37 g (90 %).

### Beispiel 2:

### Synthesevorschrift von 2-[3-(1-Hydroxy-1-methyl-ethyl)-2-(4-methylnaphthalin-1-yl)-phenyl]-propan-2-ol 2:

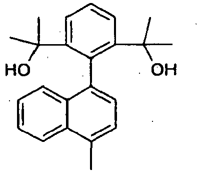

Unter Schutzgas werden 73 g (227 mmol) 2-(4-Methyl-naphthalin-1-yl)-isophthalsäuredimethylester (aus Beispiel 1) in 2000 ml THF vorgelegt und auf 0°C gekühlt. Bei dieser Temperatur wird 300 ml 2 M Methylmagnesiumchlorid-Lösung zugetropft und anschließend über Nacht auf Raumtemperatur gebracht. Man versetzt die Lösung mit 600 mL gesättigter NH₄Cl-Lösung und 900 ml Wasser/konz. HCl 8:1. Die Phasen werden getrennt und das Lösungsmittel im Vakuum entfernt. Der Gehalt an Produkt beträgt gemäß ¹H-NMR ca. 90 % bei einer Gesamtausbeute von 76.2 g (90 %).

### Beispiel 3:

### Synthesevorschrift zur Herstellung von 1,1,5,5,9-Pentamethyl-1,5-dihydro-benzo[m,n,o]aceanthrylen 3:

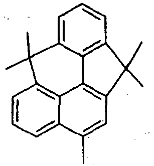

Unter Schutzgas werden 66.9 g (200 mmol) 2-[3-(1-Hydroxy-1-methylethyl)-2-(4-methyl-naphthalin-1-yl)-phenyl]-propan-2-ol (aus Beispiel 2) in 268 g (2734 mmol) Polyphosphorsäure vorgelegt und auf 0 °C gekühlt. Anschließend wird 3 h bei 100 °C gerührt und dann auf Raumtemperatur gekühlt. Unter Eiskühlung wird die Mischung mit Wasser versetzt, mit Essigsäureethylester extrahiert und das Lösungsmittel im Vakuum entfernt. Der Gehalt an Produkt beträgt gemäß ¹H-NMR ca. 96 % bei einer Gesamtausbeute von 60 g (94 %).

### Beispiel 4:

### Synthesevorschrift zur Herstellung von 3-Brom-1,1,5,5,9-pentamethyl-1,5-dihydro-benzo[m,n,o]aceanthrylen 4:

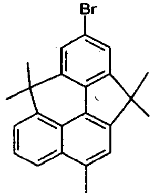

Unter Schutzgas werden 51 g (173 mmol) 1,1,5,5,9-Pentamethyl-1,5-dihydro-benzo[*m*,*n*,*o*]aceanthrylen (aus Beispiel 3) in 1500 mL Chloroform vorgelegt und auf 0 °C gekühlt. Zu dieser Lösung wird 31 g (174 mmol) NBS portionsweise zugegeben und über Nacht gerührt. Das Gemisch wird mit Na₂SO₃ Lösung versetzt, die Phasen werden getrennt und das Lösungsmittel im Vakuum entfernt. Der Gehalt an Produkt beträgt gemäß ¹H-NMR ca. 95 % bei einer Gesamtausbeute von 46 g (71 %).

### Beispiel 5:

### Synthesevorschrift von Bis-(4-tert-butyl-phenyl)-(1,1,5,5, 9-pentamethyl-1,5-dihydro-benzo[m,n,o]aceanthrylen-3-yl)-amin 5:

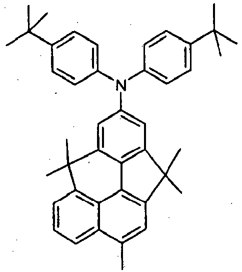

Eine entgaste Lösung von 32.7 g (86.6 mmol) 3-Brom-1,1,5,5,9-pentamethyl-1,5-dihydro-benzo[*m*,*n*,*o*]aceanthrylen (aus Beispiel 4) und 27 g (95.9 mmol) Bis-(4-tert-butyl-phenyl)-amin in 1000 ml Dioxan wird 1 h lang mit N₂ gesättigt. Danach wird die Lösung zuerst mit 0.9 ml (4.3 mmol) P(^{t}Bu)₃, dann mit 0.480 g (2.1 mmol) Palladiumacetat versetzt und anschließend 12.6 g (131 mmol) NaOtBu im festen Zustand zugegeben. Die Reaktionsmischung wird 18 h unter Rückfluss erhitzt. Nach Abkühlen auf Raumtemperatur werden vorsichtig 1000 ml Wasser zugesetzt. Die organische Phase wird mit 4 x 50 mL H₂O gewaschen, über MgSO₄ getrocknet und die Lösungsmittel im Vakuum entfernt. Das reine Produkt erhält man durch Umkristallisation. Der Gehalt an Produkt beträgt gemäß HPLC 99.9 % bei einer Gesamtausbeute von 40 g (80 %).

### Beispiel 6:

### Synthesevorschrift zur Herstellung von 3-Nitro-1,1,5,5,9-pentamethyl-1,5-dihydro-benzo[m,n,o]aceanthrylen 6:

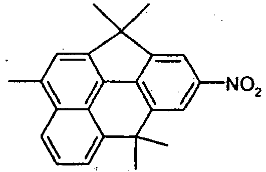

Es werden in einem 50 mL Zweihalskolben unter Schutzgasatmosphäre 12.0 mL Eisessig und 1.39 mL (33.5 mol) rauchende Salpetersäure vorsichtig unter Eiskühlung gemischt. In einem 250 mL Vierhalskolben wird unter Schutzgasatmosphäre 10.0 g (33.5 mmol) des Aromaten **3** in 75 mL Nitrobenzol gelöst. Zu dieser Lösung wird das Eisessig-Salpetersäuregemisch langsam bei 0°C zugetropft und die Reaktionsmischung wird unter DC-Kontrolle langsam auf RT gebracht. Nach vollständiger Reaktion wird der Ansatz vorsichtig auf Eiswasser gegeben, ausreichend Essigester zugegeben und die Phasen getrennt, getrocknet und eingeengt. Man erhält 9.8 g (85%) des Produktes als gelbbraunen Feststoff, der direkt in die nächste Transformation eingesetzt werden kann.

### Beispiel 7:

### Synthesevorschrift zur Herstellung von 1,1,5,5,9-Pentamethyl-1,5,8b,10b-tetrahydro-benzo[m,n,o]aceanthrylen-3-ylamin 7:

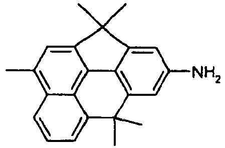

10.0 g (29.1 mmol) der Nitroverbindung **6** werden in 100 mL Methanol suspendiert und unter Schutzgasatmosphäre wird 0.74g Pd/C (10%ig) zugegeben und auf 0°C gekühlt. Bei dieser Temperatur wird in kleinen Portionen vorsichtig mit 2.9 g (78.6 mmol) NaBH4 versetzt. Die Reaktionslösung wird via DC-Kontrolle verfolgt und langsam auf Raumtemperatur gebracht. Nach vollständiger Reaktion wird unter Eiskühlung mit 100 mL Methanol versetzt und der Wasserstoff abgeleitet. Es wird anschließend bei 0°C vorsichtig mit Wasser versetzt und mit ausreichend Dichlormethan extrahiert, getrocknet und eingeengt. Das Rohprodukt wird aus Toluol/Heptan 1:25 heiß ausgerührt und man erhält 6.8 g (74%) des Produktes als hellen Feststoff.

### Beispiel 8:

### Synthesevorschrift zur Herstellung von Tris-(1,1,5,5,9-pentamethyl-1,5,8b,10b-tetrahydro-benzo[m,n,o]aceanthrylen-3-yl)-amin 8:

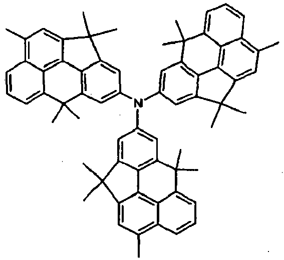

4.15 g (13.25 mmol) des Amins **7** werden mit 10.0 g (26.5 mmol) des Bromids **4** in 125 mL Toluol suspendiert und für 30 min durch N₂-Einleitung entgast. Zur Suspension werden 0.66 mL Tris-tert-butylphosphin (1 M/L in Toluol) zugespritzt und mit 59.5 mg (0.27 mmol) Pd(OAc)₂ versetzt. Es wird kurz nachentgast und dann mit 1.91 g (18.9 mmol) NaO^{t}Bu (als Feststoff entgast) versetzt und die Reaktionsmischung unter starkem Rückfluss für 3h gerührt. Nach Abkühlen der Reaktionslösung wird mit Toluol/Essigester verdünnt und über Alox B (Aktivitätsstufe 1) filtriert. Nach Kristallisation aus Heptan/Toluol 10:1 erhält man 8.7g (73%) des Produktes als weißes Pulver.

### Beispiel 9: Herstellung der OLEDs

Die Herstellung von erfindungsgemäßen OLEDs erfolgt nach einem allgemeinen Verfahren gemäß WO 04/058911, das an die hier beschriebenen Gegebenheiten (Schichtdickenvariation, verwendete Materialien) angepasst wurde.

In den folgenden Beispielen 9.1 bis 9.4 werden die Ergebnisse mehrerer OLEDs vorgestellt. Glasplättchen, die mit strukturiertem ITO (Indium Zinn Oxid) beschichtet sind, bilden die Substrate der OLEDs. Zur verbesserten Prozessierung wird 20 nm PEDOT (aus Wasser aufgeschleudert; bezogen von H. C. Starck, Goslar, Deutschland; Poly(3,4-ethylendioxy-2,5-thiophen)) auf das Substrat aufgebracht.

Die OLEDs bestehen aus folgender Schichtenfolge:
Substrat / PEDOT (20 nm) / HIL1 (5 nm) / HIL2 (110 nm bzw. 140 nm) / HTM (20 nm) / Emissionschicht = EML (30 nm) / AlQ₃ (20 nm) und abschließend eine Kathode. Die OLEDs der Beispiele 9.1 und 9.2 enthalten eine 110 nm dicke HIL2-Schicht, die der Beispiele 9.3 und 9.4 eine 140 nm dicke HIL2 Schicht.

Alle Materialien bis auf PEDOT werden in einer Vakuumkammer thermisch aufgedampft. Dabei besteht die Emissionsschicht immer aus einem Matrixmaterial (Host) und einem Dotierstoff (Dotand), der durch Coverdampfung dem Host beigemischt wird. Die Kathode wird durch eine 1 nm dicke LiF-Schicht und eine darauf abgeschiedene 100 nm dicke AI-Schicht gebildet. Tabelle 1 zeigt die chemischen Strukturen der zum Aufbau der OLEDs verwendeten Materialien.

Diese OLEDs werden standardmäßig charakterisiert; hierfür werden die Elektrolumineszenzspektren, die Effizienz (gemessen in cd/A), die Leistungseffizienz (gemessen in Im/W) in Abhängigkeit der Helligkeit, berechnet aus Strom-Spannungs-Helligkeit-Kennlinien (IUL-Kehnlinien), und die Lebensdauer bestimmt. Als Lebensdauer wird die Zeit definiert, nach der die Anfangshelligkeit von 25000 cd/m² bzw. 6000 cd/m² auf die Hälfte gesunken ist. Die Einsatzspannung ist definiert als diejenige Spannung, bei der die OLED eine Helligkeit von 1 cd/m² erreicht.

In Tabelle 2 sind die Ergebnisse zweier OLEDs (Beispiele 9.1 und 9.2) zusammengefasst, welche den Einsatz der erfindungsgemäßen Verbindungen als Lochtransportmaterialien zeigen. Als erfindungsgemäßes Lochtransportmaterial (HTM) wird die Verbindung HTM1 aus Tabelle 1 verwendet. Als Vergleich wird die Verbindung NPB gemäß dem Stand der Technik verwendet. Verglichen mit dem Stand der Technik zeichnet sich die Verbindung HTM1 gegenüber NPB durch eine erhöhte Effizienz und Lebensdauer bei praktisch unveränderter Betriebs- und Einsatzspannung aus.

Die Beispiele 9.3 und 9.4 zeigen blau emittierende OLEDs, wobei in 9.3 der Dotand D2 gemäß dem Stand der Technik und in 9.4 der erfindungsgemäße Dotand D3 zum Einsatz kommt. Wie man sieht, zeigt die erfindungsgemäße Substanz deutlich tiefblauere Farbkoordinaten, d.h. einen geringeren CIE y-Wert. Trotzdem zeigt D3 eine ähnliche Stromeffizienz (gemessen in cd/A), d.h. dass die Quanteneffizienz gegenüber dem Stand der Technik wesentlich verbessert ist, was auch in der Tabelle 2 gezeigt ist. Eine weiterer Vorteil der erfindungsgemäßen Verbindung D3 ist die verbesserte Lebensdauer gegenüber der Verbindung D2 gemäß dem Stand der Technik: Obwohl D3 tiefblauere Farbkoordinaten zeigt und deshalb für die verwendete Starthelligkeit von 6000 cd/m² bei wesentlich höherem Strom betrieben werden muss als D2, erhält man mit der erfindungsgemäßen Verbindung eine wesentliche Verbesserung der Lebensdauer um fast 50%. Dies zeigt, dass D3 eine höhere intrinsische Stabilität aufweist als D2.

**Tabelle 1**

| | |
|---|---|
| 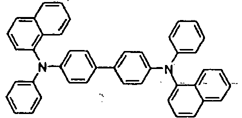 | 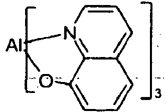 |
| NPB | AlQ₃ |
| 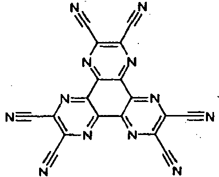 | 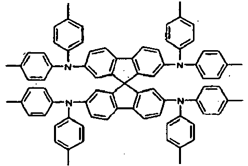 |
| HIL1 | HIL2 |
| 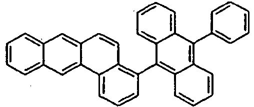 | 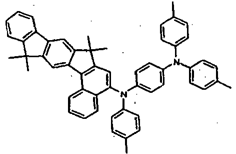 |
| H1 | D1 |
| 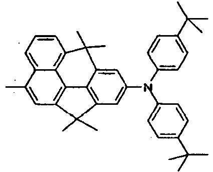 | 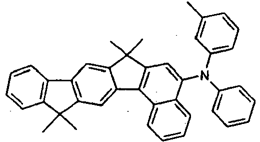 |
| HTM1 | D2 |
| 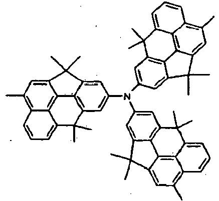 | |
| D3 | |

**Tabelle 2:**

| Beispiel | EML | HTM | Einsatzspannung | Spannung für 1000 cd/m² | Effizienz bei 1000 cd/m² | EQE bei 1000 cd/m² | Farbe | CIE x/y bei 1000 cd/m² | Lebensdauer für 25000 cd/m² |
|---|---|---|---|---|---|---|---|---|---|
| 9.1 | H1 + 10% D1 | NPB | 2.8 V | 5.0 V | 17.1 cd/A | 5.0 % | grün | 0.28/0.61 | 390 h |
| 9.2 | H1 + 10% D1 | HTM1 | 2.7 V | 5.1 V | 19.2 cd/A | 5.7% | grün | 0.28/0.60 | 420 h |
| | | | | | | | | | Lebensdauer für 6000 cd/m² |
| 9.3 | H1 + 5% D2 | NPB | 3.3 V | 6.4 V | 5.1 cd/A | 4.2% | blau | 0.142/0.151 | 110 h |
| 9.4 | H1 +5% D3 | NPB | 3.2 V | 6.1 V | 5.4 cd/A | 5.2 % | blau | 0.143/0.111 | 160 h |

## Patentansprüche

1. Verbindungen der Formeln (1), (2) oder (3) 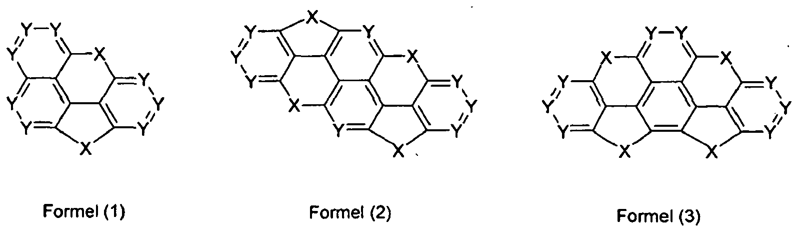 wobei gilt:
X ist jeweils unabhängig voneinander eine bivalente Brücke, ausgewählt aus B(R¹), C(R¹)₂, Si(R¹)₂, C=NR¹, C=C(R¹)₂, O, S, C=O, S=O, SO₂, N(R¹), P(R¹) und P(=O)R¹;
Y ist jeweils unabhängig voneinander CR oder N;
R ist jeweils unabhängig voneinander H, D, F, Cl, Br, I, N(R²)₂, N(Ar)₂, C(=O)Ar, P(=O)Ar₂, S(=O)Ar, S(=O)₂Ar, CR²=CR²Ar, CN, NO₂, Si(R²)₃, B(OR²)₂, OSO₂R², eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C≡C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 40 aromatischen Ringatomen, das jeweils durch einen oder mehrere nicht-aromatische Reste R substituiert sein kann, oder eine Aryloxy-oder Heteroaryloxygruppe mit 5 bis 40 aromatischen Ringatomen, die durch einen oder mehrere nicht-aromatische Reste R substituiert sein kann, oder eine Kombination dieser Systeme;
R¹ ist jeweils unabhängig voneinander H, D, F, Cl, Br, I, CN, NO₂, B(OR²)₂, Si(R²)₃, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch -R²C=CR²-, -C=C-, Si(R²)₂, Ge(R²)₂, Sn(R²)₂, C=O, C=S, C=Se, C=NR², -O-, -S-, -COO- oder -CONR²- ersetzt sein können und wobei ein oder mehrere H-Atome durch D, F, Cl, Br, I, CN oder NO₂ ersetzt sein können, oder ein Arylamin oder ein substituiertes Carbazol, das jeweils mit einem oder mehreren Resten R² substituiert sein kann, oder ein aromatisches oder heteroaromatisches Ringsystem mit 5 bis 40 aromatischen Ringatomen, das durch einen oder mehrere nicht-aromatische Reste R¹ substituiert sein kann, oder eine Aryloxy- oder Heteroaryloxygruppe mit 5 bis 40 aromatischen Ringatomen, die durch einen oder mehrere nicht-aromatische Reste R¹ substituiert sein kann, oder eine Kombination dieser Systeme; wobei zwei oder mehrere Substituenten R¹ auch miteinander ein mono- oder polycyclisches, aliphatisches oder aromatisches Ringsystem bilden können;
R² ist jeweils unabhängig voneinander H, D oder ein aliphatischer oder aromatischer Kohlenwasserstoffrest mit 1 bis 20 C-Atomen;
Ar ist jeweils unabhängig voneinander ein aromatisches oder heteroaromatisches Ringsystem mit 5 bis 40 aromatischen Ringatomen, das mit einem oder mehreren nicht-aromatischen Resten R¹ substituiert sein kann; dabei können zwei Gruppen Ar, welche an dasselbe Atom binden, auch durch eine Einfachbindung oder eine divalente Gruppe C(R¹)₂ miteinander verbunden sein,
und wobei die folgenden Verbindungen vom Anspruch nicht umfasst sind:

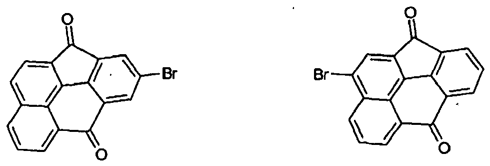

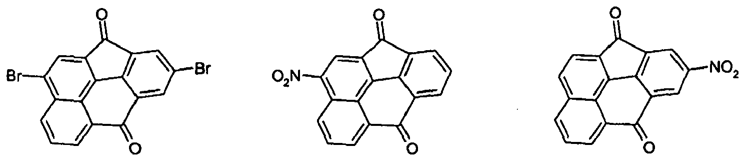

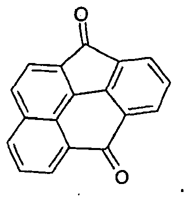

2. Verbindungen nach Anspruch 1, **dadurch gekennzeichnet, dass** die Gruppe X gleich oder verschieden bei jedem Auftreten ausgewählt ist aus C(R¹)₂, NR¹, O, S oder C=O.

3. Verbindungen nach Anspruch 1 oder 2, **dadurch gekennzeichnet, dass** maximal zwei Symbole Y in den Formeln (1) bis (3) für N und die anderen Symbole Y für CR stehen.

4. Verbindungen nach einem oder mehreren der Ansprüche 1 bis 3, **dadurch gekennzeichnet, dass** das Symbol R gleich oder verschieden bei jedem Auftreten für H, D, F, N(Ar)₂, CN, eine geradkettige Alkyl- oder Alkoxygruppe mit 1 bis 20 C-Atomen oder eine verzweigte oder cyclische Alkyl- oder Alkoxygruppe mit 3 bis 20 C-Atomen, die jeweils mit einem oder mehreren Resten R² substituiert sein kann, wobei ein oder mehrere H-Atome durch F ersetzt sein können, oder ein aromatisches oder heteroaromatisches Ringsystem mit 5 bis 25 aromatischen Ringatomen, das jeweils durch einen oder mehrere nicht-aromatische Reste R substituiert sein kann, oder eine Kombination dieser Systeme steht.

5. Verbindungen nach einem oder mehreren der Ansprüche 1 bis 4, **dadurch gekennzeichnet, dass** das Symbol R¹ gleich oder verschieden bei jedem Auftreten für H, D, eine geradkettige Alkyl- oder Alkoxygruppe mit 1 bis 20 C-Atomen oder eine verzweigte oder cyclische Alkyl- oder Alkoxygruppe mit 3 bis 20 C-Atomen, die jeweils mit einem oder mehreren Resten R² substituiert sein kann, wobei ein oder mehrere H-Atome durch F ersetzt sein können, oder ein aromatisches oder heteroaromatisches Ringsystem mit 5 bis 25 aromatischen Ringatomen, das durch einen oder mehrere nicht-aromatische Reste R¹ substituiert sein kann, oder eine Kombination dieser Systeme steht; wobei zwei oder mehrere Substituenten R¹ auch miteinander ein mono- oder polycyclisches, aliphatisches oder aromatisches Ringsystem bilden können.

6. Verbindungen nach einem oder mehreren der Ansprüche 1 bis 5, **dadurch gekennzeichnet, dass** gilt:
X ist gleich oder verschieden bei jedem Auftreten ausgewählt aus C(R¹)₂, NR¹, O, S oder C=O, insbesondere C(R¹)₂;
Y ist gleich oder verschieden bei jedem Auftreten CR¹ oder N, wobei maximal ein oder zwei Symbole Y in den Formeln (1) bis (3) für N stehen, insbesondere gleich oder verschieden bei jedem Auftreten CR;
R ist bei jedem Auftreten gleich oder verschieden H, D, F, N(Ar)₂, CN, eine geradkettige Alkyl- oder Alkoxygruppe mit 1 bis 20 C-Atomen oder eine verzweigte oder cyclische Alkyl- oder Alkoxygruppe mit 3 bis 20 C-Atomen, die jeweils mit einem oder mehreren Resten R² substituiert sein kann, wobei ein oder mehrere H-Atome durch F ersetzt sein können, oder ein aromatisches oder heteroaromatisches Ringsystem mit 5 bis 25 aromatischen Ringatomen, das jeweils durch einen oder mehrere nicht-aromatische Reste R substituiert sein kann, oder eine Kombination dieser Systeme; wobei zwei oder mehrere Reste R ein mono- oder polycyclisches, aliphatisches oder aromatisches Ringsystem bilden können; insbesondere bevorzugt sind H, N(Ar)₂, eine geradkettige Alkylgruppe mit 1 bis 10 C-Atomen oder eine verzweigte oder cyclische Alkylgruppe mit 3 bis 40 C-Atomen, insbesondere eine Methylgruppe, oder ein aromatisches oder heteroaromatisches Ringsystem mit 5 bis 25 aromatischen Ringatomen, das jeweils durch einen oder mehrere nicht-aromatische Reste R substituiert sein kann;
R¹ ist gleich oder verschieden bei jedem Auftreten H, D, eine geradkettige Alkyl- oder Alkoxygruppe mit 1 bis 20 C-Atomen oder eine verzweigte oder cyclische Alkyl- oder Alkoxygruppe mit 3 bis 20 C-Atomen, die jeweils mit einem oder mehreren Resten R² substituiert sein kann, wobei ein oder mehrere H-Atome durch F ersetzt sein können, oder ein aromatisches oder heteroaromatisches Ringsystem mit 5 bis 25 aromatischen Ringatomen, das durch einen oder mehrere nicht-aromatische Reste R¹ substituiert sein kann, oder eine Kombination dieser Systeme; wobei zwei oder mehrere Substituenten R¹ auch miteinander ein mono- oder polycyclisches, aliphatisches oder aromatisches Ringsystem bilden können; insbesondere bevorzugt ist H, eine geradkettige Alkylgruppe mit 1 bis 10 C-Atomen oder eine verzweigte oder cyclische Alkylgruppe mit 3 bis 10 C-Atomen, insbesondere eine Methylgruppe, oder ein aromatisches oder heteroaromatisches Ringsystem mit 5 bis 10 aromatischen Ringatomen, das durch einen oder mehrere nicht-aromatische Reste R¹ substituiert sein kann, insbesondere eine Phenylgruppe, die mit einem oder mehreren nicht-aromatischen Resten R¹ substituiert sein kann; wobei zwei oder mehrere Substituenten R¹ auch miteinander ein mono- oder polycyclisches, aliphatisches oder aromatisches Ringsystem bilden können;
die weiteren Symbole haben die in Anspruch 1 genannte Bedeutung.

7. Verbindungen nach einem oder mehreren der Ansprüche 1 bis 6, ausgewählt aus den Formeln (1 a) bis (3a), 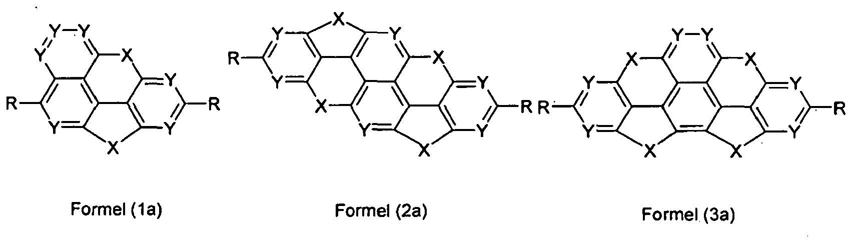 wobei die verwendeten Symbole die in Anspruch 1 aufgeführten Bedeutungen haben und maximal 2 Symbole Y in jeder Struktur für N stehen.

8. Verbindungen nach einem oder mehreren der Ansprüche 1 bis 7, ausgewählt aus den Verbindungen gemäß den Formeln (1 b) bis (3b), 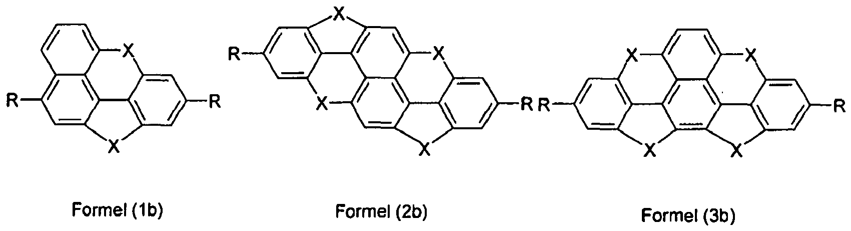 wobei R und X die in Anspruch 1 aufgeführten Bedeutungen haben.

9. Dimere, Oligomere, Polymere oder Dendrimere, enthaltend eine oder mehrere Verbindungen gemäß Formel (1), (2) oder (3): 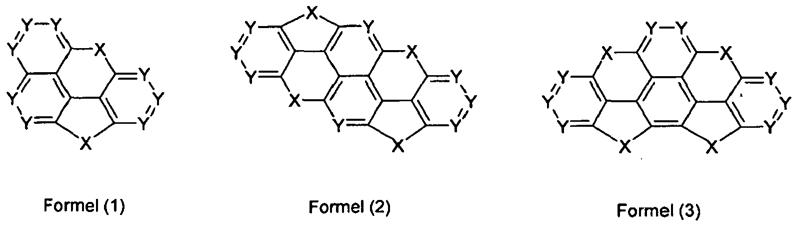 wobei die verwendeten Symbole die in Anspruch 1 aufgeführten Bedeutungen haben; und
wobei ein oder mehrere Reste R Bindungen zu der nächsten Wiederholeinheit darstellen.

10. Verfahren zur Herstellung der Verbindungen gemäß einem oder mehreren der Ansprüche 1 bis 8, **gekennzeichnet durch** die Schritte
a) Kupplung eines funktionalisierten Naphthalins oder eines funktionalisierten Anthracens oder eines entsprechenden anderen funktionalisierten Aromaten mit einer aromatischen und/oder heteroaromatischen Verbindung,
b) Bildung einer oder mehrerer bivalenter Brücken zwischen dem Naphthalin oder dem Anthracen und der aromatischen und/oder heteroaromatischen Verbindung über eine Ringschlussreaktion.

11. Verfahren nach Anspruch 10, **dadurch gekennzeichnet, dass** dieses die folgenden weiteren Reaktionsschritte umfasst:
c) Funktionalisierung des durch die Schritte a) und b) erhaltenen Grundkörpers durch Chlorierung, Bromierung oder lodierung,
d) gefolgt von Hartwig-Buchwald-Kupplung mit einem aromatischen Amin oder Suzuki-Kupplung mit einer Arylboronsäure bzw. einem Arylboronsäurederivat oder eine Polymerisation erfolgen.

12. Verwendung von Verbindungen der Formeln (1), (2) oder (3): 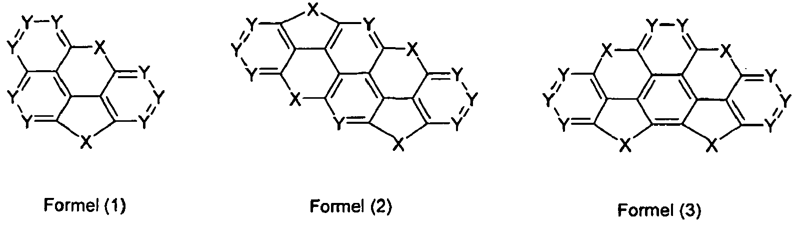 in einer organischen elektronischen Vorrichtung, vorzugsweise in einer organischen Leuchtdiode (OLED), einer organischen integrierten Schaltung (O-IC), einem organischen Feld-Effekt-Transistor (O-FT), einem organischen Dünnfilmtransistor (O-TFT), einem organischen lichtemittierenden Transistor (O-LET), einer organischen Solarzelle (O-SC), einem organischen optischen Detektor, einem organischen Photorezeptor, einem organischen Feld-Quench-Device (O-FQD), einer lichtemittierenden elektrochemischen Zelle (LEC) oder einer organischen Laserdiode (O-Laser);
wobei die verwendeten Symbole in Formeln (1), (2) und (3), die in Anspruch 1 aufgeführten Bedeutungen haben.

13. Organische elektronische Vorrichtungen, insbesondere organische Elektrolumineszenzvorrichtungen (organische Leuchtdioden oder polymere Leuchtdioden), organische integrierte Schaltungen (O-ICs), organische Feld-Effekt-Transistoren (O-FETs), organische Dünnfilmtransistoren (O-TFTs), organische lichtemittierende Transistoren (O-LETs), organische Solarzellen (O-SCs), organische optische Detektoren, organische Photorezeptoren, organische Feld-Quench-Devices (O-FQDs), lichtemittierende elektrochemische Zellen (LECs) und organische Laserdioden (O-Laser), enthaltend eine oder mehrere Verbindungen der Formeln (1), (2) oder (3): 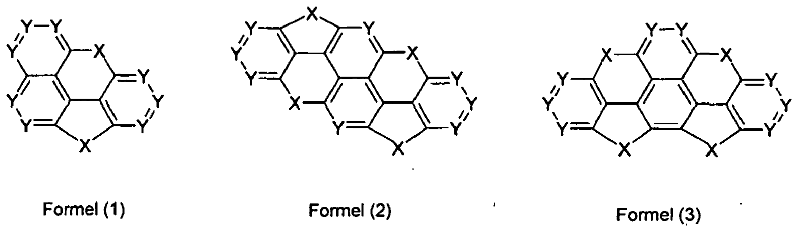 wobei die verwendeten Symbole die in Anspruch 1 aufgeführten Bedeutungen haben.

14. Organische Schicht, enthaltend eine oder mehrere Verbindungen nach einem oder mehreren der Ansprüche 1 bis 9.

15. Organische elektronische Vorrichtung nach Anspruch 13, **dadurch gekennzeichnet, dass** die Verbindung nach einem oder mehreren der Ansprüche 1 bis 9 als emittierende Verbindungen in einer emittierenden Schicht und/oder als Hostmaterial für fluoreszierende oder phosphoreszierende Emitter in einer emittierenden Schicht und/oder als Lochtransportmaterial in einer Lochinjektions- bzw. Lochtransportschicht und/oder als Elektronenblockiermaterial in einer Elektronenblockierschicht und/oder als Lochblockiermaterial in einer Lochblockierschicht und/oder als Elektronentransportmaterial in einer Elektroneninjektions- oder Elektronentransportschicht eingesetzt wird.

## Claims

1. Compounds of the formula (1), (2) or (3), 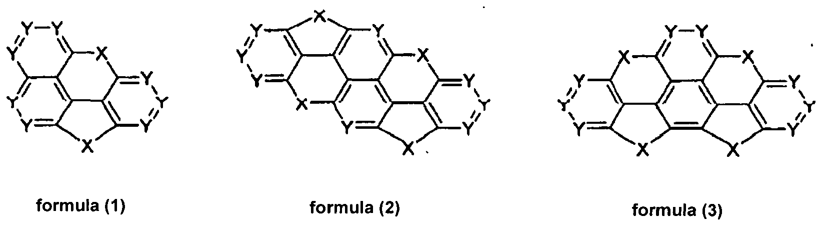 where:
X is in each case, independently of one another, a divalent bridge selected from B(R¹), C(R¹)₂, Si(R¹)₂, C=NR¹, C=C(R¹)₂, O, S, C=O, S=O, SO₂, N(R¹), P(R¹) and P(=O)R¹;
Y is in each case, independently of one another, CR or N;
R is in each case, independently of one another, H, D, F, Cl, Br, I, N(R²)₂, N(Ar)₂, C(=O)Ar, P(=O)Ar₂, S(=O)Ar, S(=O)₂Ar, CR²=CR²Ar, CN, NO₂, Si(R²)₃, B(OR²)₂, OSO₂R², a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals R², where one or more non-adjacent CH₂ groups may be replaced by R²C=CR², C=C, Si(R²)₂, Ge(R²)₂, Sn(R²)₂, C=O, C=S, C=Se, C=NR², P(=O)(R²), SO, SO₂, NR², O, S or CONR² and where one or more H atoms may be replaced by D, F, Cl, Br, I, CN or NO₂, or an aromatic or heteroaromatic ring system having 5 to 40 aromatic ring atoms, which may in each case be substituted by one or more non-aromatic radicals R, or an aryloxy or heteroaryloxy group having 5 to 40 aromatic ring atoms, which may be substituted by one or more non-aromatic radicals R, or a combination of these systems;
R¹ is in each case, independently of one another, H, D, F, Cl, Br, I, CN, NO₂, B(OR²)₂, Si(R²)₃, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals R², where one or more non-adjacent CH₂ groups may be replaced by -R²C=CR²-, -C=C-, Si(R²)₂, Ge(R²)₂, Sn(R²)₂, C=O, C=S, C=Se, C=NR², -O-, -S-, -COO- or -CONR²- and where one or more H atoms may be replaced by D, F, Cl, Br, I, CN or NO₂, or an arylamine or a substituted carbazole, each of which may be substituted by one or more radicals R², or an aromatic or heteroaromatic ring system having 5 to 40 aromatic ring atoms, which may be substituted by one or more non-aromatic radicals R¹, or an aryloxy or heteroaryloxy group having 5 to 40 aromatic ring atoms, which may be substituted by one or more non-aromatic radicals R¹, or a combination of these systems; where two or more substituents R¹ may also form a mono- or polycyclic, aliphatic or aromatic ring system with one another;
R² is in each case, independently of one another, H, D or an aliphatic or aromatic hydrocarbon radical having 1 to 20 C atoms;
Ar is in each case, independently of one another, an aromatic or heteroaromatic ring system having 5 to 40 aromatic ring atoms, which may be substituted by one or more non-aromatic radicals R¹; two groups Ar here which are bonded to the same atom may also be connected to one another by a single bond or a divalent group C(R¹)₂,
and where the following compounds are not covered by the claim:

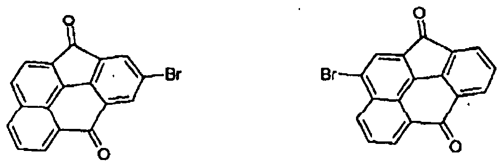

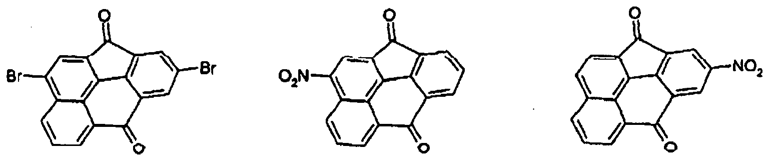

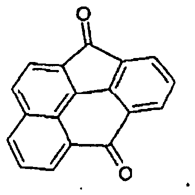

2. Compounds according to Claim 1, **characterised in that** the group X is selected, identically or differently on each occurrence, from C(R¹)₂, NR¹, O, S or C=O.

3. Compounds according to Claim 1 or 2, **characterised in that** a maximum of two symbols Y in the formulae (1) to (3) stand for N and the other symbols Y stand for CR.

4. Compounds according to one or more of Claims 1 to 3, **characterised in that** the symbol R stands, identically or differently on each occurrence, for H, D, F, N(Ar)₂, CN, a straight-chain alkyl or alkoxy group having 1 to 20 C atoms or a branched or cyclic alkyl or alkoxy group having 3 to 20 C atoms, each of which may be substituted by one or more radicals R², where one or more H atoms may be replaced by F, or an aromatic or heteroaromatic ring system having 5 to 25 aromatic ring atoms, which may in each case be substituted by one or more non-aromatic radicals R, or a combination of these systems.

5. Compounds according to one or more of Claims 1 to 4, **characterised in that** the symbol R¹ stands, identically or differently on each occurrence, for H, D, a straight-chain alkyl or alkoxy group having 1 to 20 C atoms or a branched or cyclic alkyl or alkoxy group having 3 to 20 C atoms, each of which may be substituted by one or more radicals R², where one or more H atoms may be replaced by F, or an aromatic or heteroaromatic ring system having 5 to 25 aromatic ring atoms, which may be substituted by one or more non-aromatic radicals R¹, or a combination of these systems; where two or more substituents R¹ may also form a mono- or polycyclic, aliphatic or aromatic ring system with one another.

6. Compounds according to one or more of Claims 1 to 5, **characterised in that**:
X is selected, identically or differently on each occurrence, from C(R¹)₂, NR¹, O, S or C=O, in particular C(R¹)₂;
Y is, identically or differently on each occurrence, CR¹ or N, where a maximum of one or two symbols Y in the formulae (1) to (3) stand for N, in particular, identically or differently on each occurrence, CR;
R is on each occurrence, identically or differently, H, D, F, N(Ar)₂, CN, a straight-chain alkyl or alkoxy group having 1 to 20 C atoms or a branched or cyclic alkyl or alkoxy group having 3 to 20 C atoms, each of which may be substituted by one or more radicals R², where one or more H atoms may be replaced by F, or an aromatic or heteroaromatic ring system having 5 to 25 aromatic ring atoms, which may in each case be substituted by one or more non-aromatic radicals R, or a combination of these systems; where two or more radicals R may form a mono- or polycyclic, aliphatic or aromatic ring system; particular preference is given to H, N(Ar)₂, a straight-chain alkyl group having 1 to 10 C atoms or a branched or cyclic alkyl group having 3 to 40 C atoms, in particular a methyl group, or an aromatic or heteroaromatic ring system having 5 to 25 aromatic ring atoms, which may in each case be substituted by one or more non-aromatic radicals R;
R¹ is, identically or differently on each occurrence, H, D, a straight-chain alkyl or alkoxy group having 1 to 20 C atoms or a branched or cyclic alkyl or alkoxy group having 3 to 20 C atoms, each of which may be substituted by one or more radicals R², where one or more H atoms may be replaced by F, or an aromatic or heteroaromatic ring system having 5 to 25 aromatic ring atoms, which may be substituted by one or more non-aromatic radicals R¹, or a combination of these systems; where two or more substituents R¹ may also form a mono- or polycyclic, aliphatic or aromatic ring system with one another; particular preference is given to H, a straight-chain alkyl group having 1 to 10 C atoms or a branched or cyclic alkyl group having 3 to 10 C atoms, in particular a methyl group, or an aromatic or heteroaromatic ring system having 5 to 10 aromatic ring atoms, which may be substituted by one or more non-aromatic radicals R¹, in particular a phenyl group, which may be substituted by one or more non-aromatic radicals R¹; where two or more substituents R¹ may also form a mono- or polycyclic, aliphatic or aromatic ring system with one another;
the other symbols have the meaning given in Claim 1.

7. Compounds according to one or more of Claims 1 to 6, selected from the formulae (1a) to (3a), 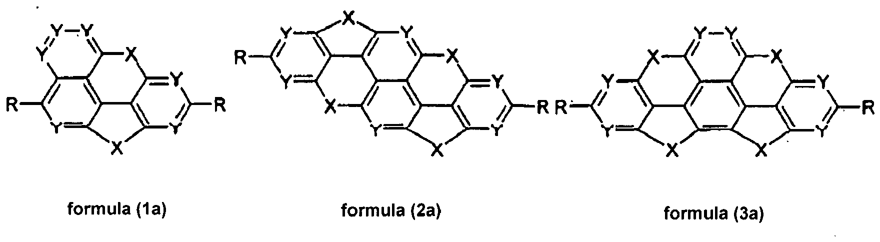 where the symbols used have the meanings given in Claim 1 and a maximum of 2 symbols Y in each structure stand for N.

8. Compounds according to one or more of Claims 1 to 7, selected from the compounds of the formulae (1 b) to (3b), 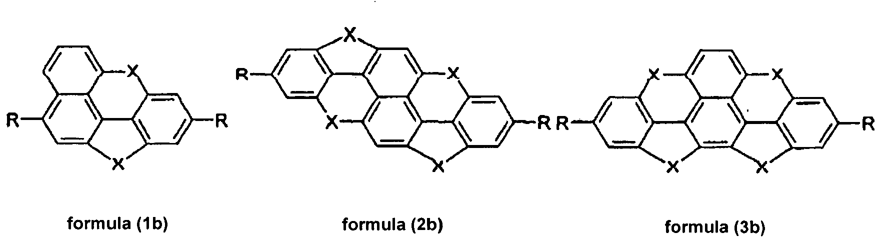 where R and X have the meanings given in Claim 1.

9. Dimers, oligomers, polymers or dendrimers containing one or more compounds of the formula (1), (2) or (3), 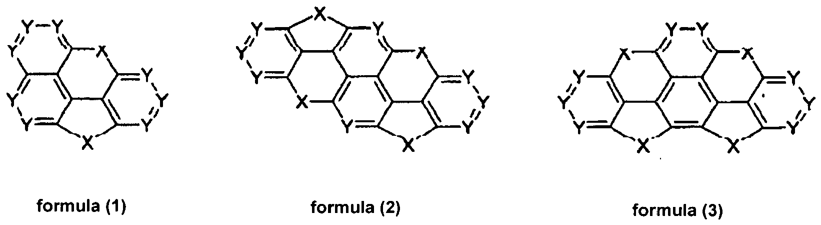 where the symbols used have the meanings given in Claim 1; and where one or more radicals R represent bonds to the next recurring unit.

10. Process for the preparation of the compounds according to one or more of Claims 1 to 8, **characterised by** the steps
a) coupling of a functionalised naphthalene or a functionalised anthracene or a corresponding other functionalised aromatic compound to an aromatic and/or heteroaromatic compound,
b) formation of one or more divalent bridges between the naphthalene or the anthracene and the aromatic and/or heteroaromatic compound via a ring-closure reaction.

11. Process according to Claim 10, **characterised in that** this includes the following further reaction steps:
c) functionalisation of the parent structure obtained by steps a) and b) by chlorination, bromination or iodination,
d) followed by Hartwig-Buchwald coupling to an aromatic amine or Suzuki coupling to an arylboronic acid or an arylboronic acid derivative or a polymerisation.

12. Use of compounds of the formula (1), (2) or (3), 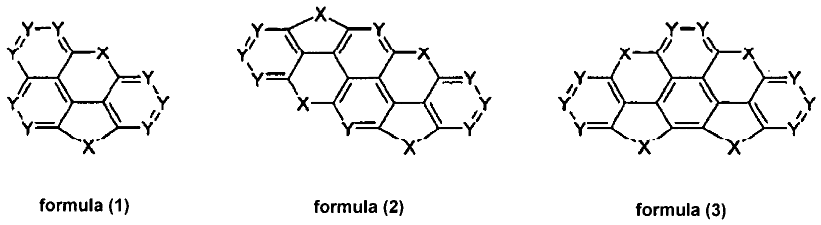 in an organic electronic device, preferably in an organic light-emitting diode (OLED), an organic integrated circuit (O-IC), an organic field-effect transistor (O-FET), an organic thin-film transistor (O-TFT), an organic light-emitting transistor (O-LET), an organic solar cell (O-SC), an organic optical detector, an organic photoreceptor, an organic field-quench device (O-FQD), a light-emitting electrochemical cell (LEC) or an organic laser diode (O-laser);
where the symbols used in formulae (1), (2) and (3) have the meanings given in Claim 1.

13. Organic electronic devices, in particular organic electroluminescent devices (organic light-emitting diodes or polymeric light-emitting diodes), organic integrated circuits (O-ICs), organic field-effect transistors (O-FETs), organic thin-film transistors (O-TFTs), organic light-emitting transistors (O-LETs), organic solar cells (O-SCs), organic optical detectors, organic photoreceptors, organic field-quench devices (O-FQDs), light-emitting electrochemical cells (LECs) and organic laser diodes (O-lasers), comprising one or more compounds of the formula (1), (2) or (3), 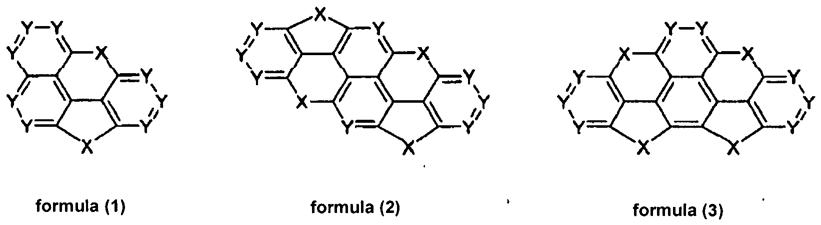 where the symbols used have the meanings given in Claim 1.

14. Organic layer comprising one or more compounds according to one or more of Claims 1 to 9.

15. Organic electronic device according to Claim 13, **characterised in that** the compound according to one or more of Claims 1 to 9 is employed as emitting compound in an emitting layer and/or as host material for fluorescent or phosphorescent emitters in an emitting layer and/or as hole-transport material in a hole-injection or hole-transport layer and/or as electron-blocking material in an electron-blocking layer and/or as hole-blocking material in a hole-blocking layer and/or as electron-transport material in an electron-injection or electron-transport layer.

## Revendications

1. Composés de la formule (1), (2) ou (3), 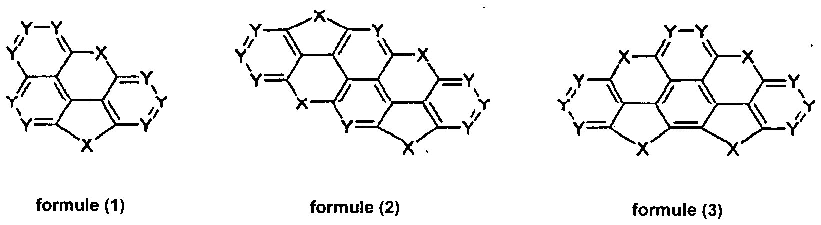 dans lesquelles :
X est dans chaque cas, de façon indépendant l'un de l'autre, un pont divalent choisi pari B(R¹), C(R¹)₂, Si(R¹)₂, C=NR¹, C=C(R¹)₂, O, S, C=O, S=O, SO₂, N(R¹), P(R¹) et P(=O)R¹;
Y est dans chaque cas, de façon indépendant l'un de l'autre, CR ou N;
R est dans chaque cas, de façon indépendant l'un de l'autre, H, D, F, Cl, Br, I, N(R²)₂, N(Ar)₂, C(=O)Ar, P(=O)Ar₂, S(=O)Ar, S(=O)₂Ar, CR²=CR²Ar, CN, NO₂, Si(R²)₃, B(OR²)₂, OSO₂R², un groupe alkyle, alcoxy ou thioalcoxy en chaîne droite ayant 1 à 40 atomes de C ou un groupe alkyle, alcoxy ou thioalcoxy ramifié ou cyclique ayant 3 à 40 atomes de C, dont chacun peut être substitué par un ou plusieurs radicaux R², où un ou plusieurs groupes CH₂ non adjacents peuvent être replacés par R²C=CR², C=C, Si(R²)₂, Ge(R²)₂, Sn(R²)₂, C=O, C=S, C=Se, C=NR², P(=O)(R²), SO, SO₂, NR², O, S ou CONR² et où un ou plusieurs atomes de H peuvent être remplacés par D, F, Cl, Br, I, CN ou NO₂, ou un système de cycle aromatique ou hétéroaromatique ayant 5 à 40 atomes de cycle aromatique, qui peut dans chaque cas être substitué par un ou plusieurs radicaux non aromatiques R, ou un groupe aryloxy ou hétéroaryloxy ayant 5 à 40 atomes de cycle aromatique, qui peut être substitué par un ou plusieurs radicaux non aromatiques R, ou une combinaison de ces systèmes;
R¹ est dans chaque cas, de façon indépendant l'un de l'autre, H, D, F, Cl, Br, I, CN, NO₂, B(OR²)₂, Si(R²)₃, un groupe alkyle, alcoxy ou thioalcoxy en chaîne droite ayant 1 à 40 atomes de C ou un groupe alkyle, alcoxy ou thioalcoxy ramifié ou cyclique ayant 3 à 40 atomes de C, dont chacun peut être substitué par un ou plusieurs radicaux R², où un ou plusieurs groupes CH₂ non adjacents peuvent être replacés par -R²C=CR²-, -C=C-, Si(R²)₂, Ge(R²)₂, Sn(R²)₂, C=O, C=S, C=Se, C=NR², -O-, -S-, -COO- ou -CONR²- et où un ou plusieurs atomes de H peuvent être remplacés par D, F, Cl, Br, I, CN ou NO₂, ou un arylamine ou un carbazole substitué, dont chacun peut être substitué par un ou plusieurs radicaux R², ou un système de cycle aromatique ou hétéroaromatique ayant 5 à 40 atomes de cycle aromatique, qui peut être substitué par un ou plusieurs radicaux non aromatiques R¹, ou un groupe aryloxy ou hétéroaryloxy ayant 5 à 40 atomes de cycle aromatique, qui peut être substitué par un ou plusieurs radicaux non aromatiques R¹, ou une combinaison de ces systèmes ; où deux ou plus de deux substituants R¹ peuvent également former un système de cycle aliphatique ou aromatique l'un avec l'autre ;
R² est dans chaque cas, de façon indépendant l'un de l'autre, H, D ou un radical hydrocarbone aliphatique ou aromatique ayant 1 à 20 atomes de C;
Ar est dans chaque cas, de façon indépendant l'un de l'autre, un système de cycle aromatique ou hétéroaromatique ayant 5 à 40 atomes de cycle aromatique, qui peut être substitué par un ou plusieurs radicaux non aromatiques R¹; deux groupes Ar ici qui sont liés au même atome peuvent également être connectés à un autre par une liaison simple ou un groupe divalent C(R¹)₂,
et où les composés qui suivent ne sont pas couvets par la revendication :

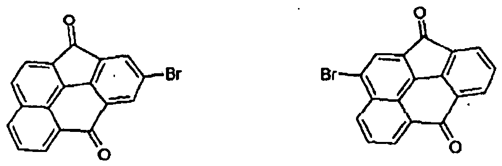

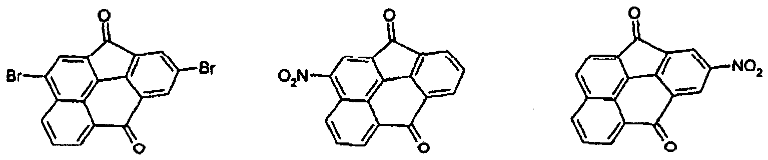

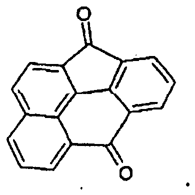

2. Composés selon la revendication 1, **caractérisés en ce que** le groupe X est choisi, de façon identique ou différente à chaque occurrence, à partir de C(R¹)₂, NR¹, O, S ou C=O.

3. Composés selon la revendication 1 ou 2, **caractérisés en ce qu'**un maximum de deux symboles Y in les formules (1) à (3) représente N et les autres symboles Y représentent CR.

4. Composés selon une ou plusieurs des revendications 1 à 3, **caractérisés en ce que** le symbole R représente, de façon identique ou différente à chaque occurrence, H, D, F, N(Ar)₂, CN, un groupe alkyle ou alcoxy en chaîne droite ayant 1 à 20 atomes de C ou un groupe alkyle ou alcoxy ramifié ou cyclique ayant 3 à 20 atomes de C, dont chacun peut être substitué par un ou plusieurs radicaux R², où un ou plusieurs atomes de H peuvent être remplacés par F, ou un système de cycle aromatique ou hétéroaromatique ayant 5 à 25 atomes de cycle aromatique, lequel peut dans chaque cas être substitué par un ou plusieurs radicaux non aromatiques R, ou une combinaison de ces systèmes.

5. Composés selon une ou plusieurs des revendications 1 à 4, **caractérisés en ce que** le symbole R¹ représente, de façon identique ou différente à chaque occurrence, H, D, un groupe alkyle ou alcoxy en chaîne droite ayant 1 à 20 atomes de C ou un groupe alkyle ou alcoxy ramifié ou cyclique ayant 3 à 20 atomes de C, dont chacun peut être substitué par un ou plusieurs radicaux R², où un ou plusieurs atomes de H peuvent être remplacés par F, ou un système de cycle aromatique ou hétéroaromatique ayant 5 à 25 atomes de cycle aromatique, lequel peut dans chaque cas être substitué par un ou plusieurs radicaux non aromatiques R¹, ou une combinaison de ces systèmes ; où deux ou plus de deux substituants R¹ peuvent également former un système de cycle mono- ou polycyclique, aliphatique ou aromatique l'un avec l'autre.

6. Composés selon une ou plusieurs des revendications 1 à 5, **caractérisés en ce que** :
X est choisi, de façon identique ou différente à chaque occurrence, à parti de C(R¹)₂, NR¹, O, S ou C=O, en particulier C(R¹)₂;
Y est choisi, de façon identique ou différente à chaque occurrence, CR¹ ou N, où un maximum de un ou deux symboles Y dans les formules (1) à (3) représentent N, en particulier, de façon identique ou différente à chaque occurrence, CR ;
R est à chaque occurrence, de façon identique ou différente, H, D, F, N(Ar)₂, CN, un groupe alkyle ou alcoxy en chaîne droite ayant 1 à 20 atomes de C ou un groupe alkyle ou alcoxy ramifié ou cyclique ayant 3 à 20 atomes de C, dont chacun peut être substitué par un ou plusieurs radicaux R², où un ou plusieurs atomes de H peuvent être remplacés par F, ou un système de cycle aromatique ou hétéroaromatique ayant 5 à 25 atomes de cycle aromatique, lequel dans chaque cas peut être substitué par un ou plusieurs radicaux R, ou une combinaison de ces systèmes; où deux ou plus de deux radicaux R peuvent former un système de cycle mono- ou polycyclique, aliphatique ou aromatique ; préférence particulière est donnée à H, N(Ar)₂, un groupe alkyle en chaîne droite ayant 1 à 10 atomes de C ou un groupe alkyle ramifié ou cyclique ayant 3 à 40 atomes de C, en particulier un groupe méthyle, ou un système de cycle aromatique ou hétéroaromatique ayant 5 à 25 atomes de cycle aromatique, lequel peut dans chaque cas être substitué par un ou plusieurs radicaux non aromatiques R ;
R¹ est, de façon identique ou différente à chaque occurrence, H, D, un groupe alkyle ou alcoxy en chaîne droite ayant 1 à 20 atomes de C ou un groupe alkyle ou alcoxy ramifié ou cyclique ayant 3 à 20 atomes de C, dont chacun peut être substitué par un ou plusieurs radicaux R², où un ou plusieurs atomes de H peuvent être remplacés par F, ou un système de cycle aromatique ou hétéroaromatique ayant 5 à 25 atomes de cycle aromatique, lequel peut être substitué par un ou plusieurs radicaux non aromatiques R¹, ou une combinaison de ces systèmes; où deux ou plus de deux substituants R¹ peuvent également former un système de cycle mono- ou polycyclique, aliphatique ou aromatique l'un avec l'autre ; préférence particulière est donnée à H, un groupe alkyle en chaîne droite ayant 1 à 10 atomes de C ou un groupe alkyle ramifié ou cyclique ayant 3 à 40 atomes de C, en particulier un groupe méthyle, ou un système de cycle aromatique ou hétéroaromatique ayant 5 à 25 atomes de cycle aromatique, lequel peut être substitué par un ou plusieurs radicaux non aromatiques R¹ ; en particulier un groupe phényle, lequel peut être substitué par un ou plusieurs radicaux non aromatiques R¹ ; où deux ou plus de deux substituants R¹ peuvent également former un système de cycle mono- ou polycyclique aliphatique ou aromatique l'un avec l'autre ;
les autres symboles ont la signification dans la revendication 1.

7. Composés selon une ou plusieurs des revendications 1 à 6, choisis parmi les formules (1a) à (3a), 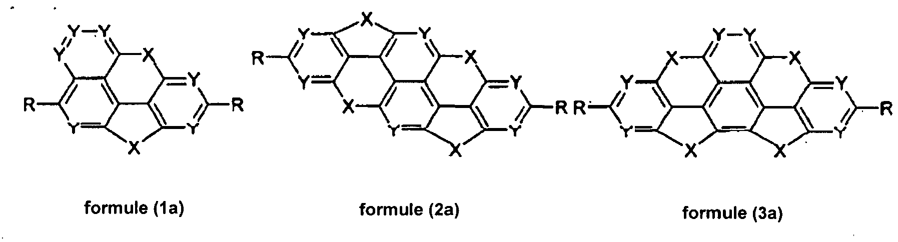 dans lesquelles les symboles utilisés ont les significations données dans la revendication 1 et un maximum de 2 symboles Y dans chaque structure représentent N.

8. Composés selon une ou plusieurs des revendications 1 à 7, choisis parmi les formules (1b) à (3b), 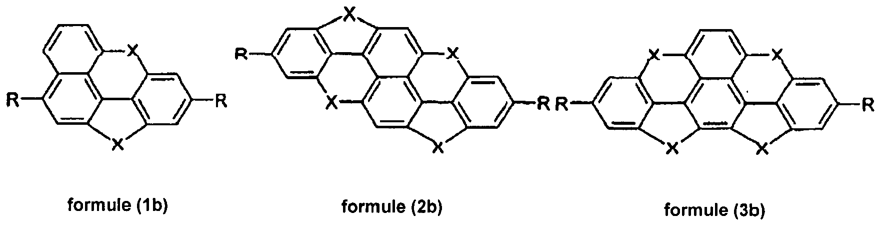 dans lesquelles R et X ont les significations données dans la revendication 1.

9. Dimères, oligomères, polymères ou dendrimères contenant un ou plusieurs composés de la formule (1), (2) ou (3), 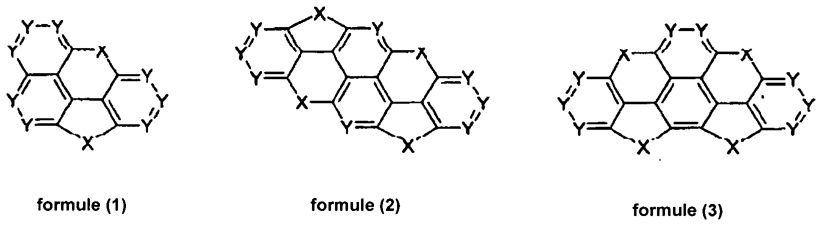 dans lesquelles les symboles utilisés ont les significations données dans la revendication 1; et
dans lesquelles un ou plusieurs radicaux R représente des liaisons à l'unité récurrente suivante.

10. Procédé pour la préparation des composés selon une ou plusieurs des revendications 1 à 8, **caractérisé par** les étapes :
a) couplage d'un naphtalène fonctionnalisé ou d'un anthracène fonctionnalisé ou d'un autre composé aromatique fonctionnalisé correspondant à un composé aromatique ou hétéroaromatique,
b) formation d'un ou plusieurs ponts divalents entre le naphtalène ou l'anthracène et le composé aromatique et/ou hétéroaromatique via une réaction de fermeture de cycle.

11. Procédé selon la revendication 10, **caractérisé en ce qu'**il inclut les étapes de réaction supplémentaires qui suivent :
c) fonctionnalisation de la structure parente obtenue par les étapes a) et b) par chlorination, bromination ou iodination,
d) suivie par un couplage de Hartwig-Buchwald à un amine aromatique ou par un couplage de Suzuki à un acide arylboronique ou un dérivé d'acide arylboronique ou une polymérisation.

12. Utilisation de composés de la formule (1), (2) ou (3), 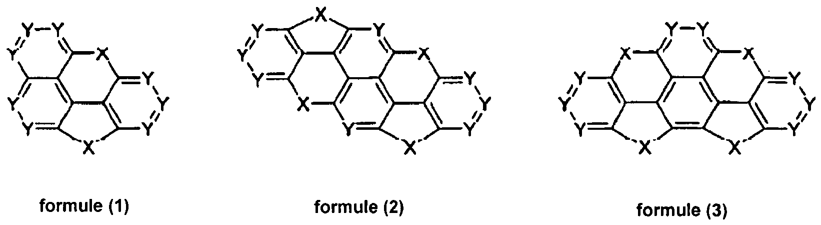 dans un dispositif électronique organique, de préférence dans une diode émettrice de lumière organique (OLED), un circuit intégré organique (O-IC), un transistor à effet de champ organique (O-FET), un transistor à film mince organique (O-TFT), un transistor émetteur de lumière organique (O-LET), une cellule solaire organique (O-SC), un détecteur optique organique, un photorécepteur organique, un dispositif à extinction de champ organique (O-FQD), une cellule électrochimique émettrice de lumière (LEC) ou une diode laser organique (O-laser);
où les symboles utilisés dans les formules (1), (2) et (3) ont les significations données dans la revendication 1.

13. Dispositifs électroniques organiques, en particulier dispositifs électroluminescents organiques (diodes émettrices de lumière organiques ou diodes émettrices de lumière polymériques), circuits intégrés organiques (O-ICs), transistors à effet de champ organiques (O-FETs), transistors à film mince organiques (O-TFTs), transistors émetteurs de lumière organiques (O-LETs), cellules solaires organiques (O-SCs), détecteurs optiques organiques, photorécepteurs organiques, dispositifs à extinction de champ organiques (O-FQDs), cellules électrochimiques émettrices de lumière (LECs) et diodes laser organiques (O-lasers), comprenant un ou plusieurs composés de la formule (1), (2) ou (3), 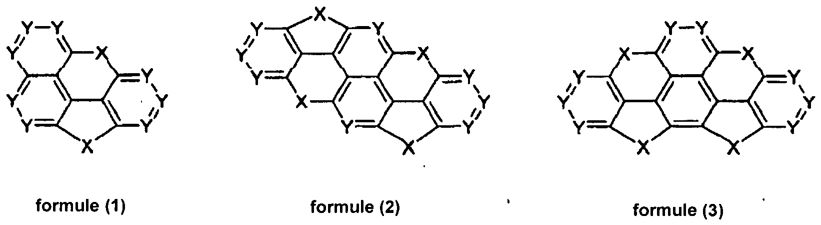 dans lesquelles les symboles utilisés ont les significations données dans la revendication 1.

14. Couche organique comprenant un ou plusieurs composés selon une ou plusieurs des revendications 1 à 9.

15. Dispositif électronique organique selon la revendication 13, **caractérisé en ce que** le composé selon une ou plusieurs des revendications 1 à 9 est employé comme composé d'émission dans une couche d'émission et/ou comme matériau hôte pour des émetteurs fluorescents ou phosphorescents dans une couche d'émission et/ou comme matériau de transport de trous dans une couche d'injection de trous ou une couche de transport de trous et/ou comme matériau de blocage d'électrons dans une couche de blocage d'électrons et/ou comme matériau de blocage de trous dans une couche de blocage de trous et/ou comme matériau de transport d'électrons dans une couche d'injection d'électrons ou une couche de transport d'électrons.
